# EUROPEAN PATENT SPECIFICATION

(11) **EP 2 494 372 B1**
(45) Date of publication and mention of the grant of the patent: **04.12.2013**
(21) Application number: 10826033.2
(22) Date of filing: 08.10.2010
(51) Int. Cl.: G01R 31/36, G01R 27/14

(54) **DEVICE AND METHOD FOR TESTING INTERNAL RESISTANCE OF BATTERY PACK**
VORRICHTUNG UND VERFAHREN ZUM ÜBERPRÜFEN DES INTERNEN WIDERSTANDS EINES BATTERIEPACKS
DISPOSITIF ET PROCÉDÉ POUR TESTER LA RÉSISTANCE INTERNE D'UN ENSEMBLE D'ACCUMULATEURS

(30) Priority: 29.10.2009 CN 200910109967
(43) Date of publication of application: 05.09.2012
(73) Proprietor: BYD Company Limited, Shenzhen, Guangdong 518118 (CN)
(72) Inventor: SHEN, Xiaofeng, Guangdong 518118 (CN); PENG, Junna, Guangdong 518118 (CN)
(74) Representative: HOFFMANN EITLE
(86) International application number: PCT/CN2010/077603
(87) International publication number: WO 2011/050670

(56) References cited:
- US-A- 3 873 911
- US-A- 5 250 904
- US-A1- 2005 218 915
- US-A1- 2006 001 429
- US-A1- 2007 194 791
- US-A1- 2009 009 134
- US-B1- 6 388 448

## Description

### TECHNICAL FIELD

The present disclosure relates to device and method of testing an internal resistance of a battery pack, more particularly to device and method of testing the internal resistance of a battery pack used in an electric vehicle or a hybrid vehicle.

### BACKGROUND

The battery pack plays an important role in the electric vehicle and the hybrid vehicle. The battery pack system is generally connected in series. Deterioration of the status of some cells in the battery pack may affect the whole capability of the battery pack directly. That is, the whole capability of the battery pack is decided by the capability of one or more cells whose status is deteriorated most seriously. Therefore, it is necessary to accurately measure the status of each cell so as to avoid failure of the battery pack.

Conventionally, the method of testing the internal resistance of the battery pack comprises a direct current discharge method and an alternating current injection method. The direct current discharge method comprises steps of generating an instant load current by a battery pack, then measuring the instant change of the voltage at the electrode pole of the battery pack and calculating the internal resistance of the battery pack.

The disadvantages of the direct current discharge method are as follows.

Because the remaining capability needs to be measured and displayed frequently, it is required to frequently measure the internal resistance, thereby influencing the normal running of the electric vehicle and reducing the remaining capability of the battery pack. Moreover, the number of the battery packs in the electric vehicle is large, which may greatly waste capability of the battery pack. The direct current discharge method is only suitable to measure the battery pack with large voltage range, because it is impossible to load the battery pack having small voltage range with a large current of about several ten ampere in a short period of time of several seconds. The electrodes in the battery pack may be damaged when the large current passes through the battery pack, thereby influencing the measurement accuracy. In addition, the direct current discharge method can not be used in the hybrid vehicle.

The alternating current injection method comprises applying a constant alternating audio current source to two terminals of the battery pack, then detecting the excitation voltage between two terminals of the battery pack and the phase difference therebetween. The internal resistance of the battery pack may be obtained according to Ohm's law.

In the alternating current injection method, the safe online detecting of the internal resistance of the battery pack may be realized without discharging of the battery pack, which may not influence the performance of the battery pack. However, similarly to the direct current discharge method, the alternating current injection method has the problem that the detected voltage range of the battery pack is limited. Moreover, the trigonometric function calculation needs to be performed in MCU (Microprogrammed Control Unit) for the alternating current injection method. Therefore, the hardware circuit and algorithm are quite complicated, thereby influencing the measurement accuracy.

Document US 2005/0218915 A1 discloses a method for testing electrochemical cells that applies a portion of a cycle of a low-frequency excitation waveform to a cell under test while maintaining an amplitude of the excitation waveform below a threshold value.

Document US 3873911 discloses a self-contained electronic device for testing storage batteries by using a modified bridge circuit to determine the inverse dynamic resistance.

### SUMMARY

The present disclosure is directed to solve at least one problem existing in the prior art. Accordingly, device and method for testing an internal resistance of a battery pack having different voltage ranges are provided, thereby effectively improving the accuracy of measuring the internal resistance.

According to an aspect of the disclosure, an internal resistance testing device is provided, which comprises a battery pack; an adjustable resistance connected with the battery pack to form a loop circuit; an excitation source coupled to the loop circuit to apply an excitation to the loop circuit so as to generate an excitation current in the loop circuit; a sampling unit coupled to the loop circuit and used to collect an excitation voltage *V*₂ between two terminals of the battery pack, an excitation voltage *V*₁, between two terminals of the adjustable resistance and a resistance value *R* of the adjustable resistance; and a control unit coupled to the sampling unit and used to calculate an internal resistance of the battery pack based on the excitation voltage *V*₂, the excitation voltage *V*₁ and the resistance value R which are collected by the sampling unit at a time when the excitation voltage *V*₂ is substantially equal to a range voltage *V*_{(standard)} of the sampling unit.

According to another aspect of the present disclosure, an internal resistance testing method using the internal resistance testing device according to the first aspect is provided. The method comprises steps of: a) applying an excitation to the loop circuit by the excitation source; b) collecting an excitation voltage *V*₂ between the two terminals of the battery pack, an excitation voltage *V*₁ between the two terminals of the adjustable resistance and the resistance value *R* of the adjustable resistance by the sampling unit; c) adjusting the resistance value *R* of the adjustable resistance to equate the excitation voltage *V*₂ between the two terminals of the battery pack with the range voltage *V*_{(standard)} of the sampling unit; and d) calculating an internal resistance *r* of the battery pack based on the excitation voltage *V*₂, the excitation voltage *V*₁, and the resistance value R of the adjustable resistance which are collected at a time when the excitation voltage *V*₂ is substantially equal to a range voltage *V*_{(standard)} of the sampling unit.
according to embodiments of the present embodiments, by adjusting the resistance value *R* of the adjustable resistance to equate the excitation voltage between two terminals of the adjustable resistance with the range voltage of the sampling unit, testing of the internal resistance of the battery pack having different voltage ranges may be achieved. Moreover, by adjusting the adjustable resistance, the adjustment of the current and the voltage in the loop circuit may be realized, so that the excitation voltage between two terminals of the adjustable resistance may be equal to the range voltage of the sampling unit. Therefore, the accuracy of measuring the internal resistance of the battery pack may be improved effectively.

Additional aspects and advantages of the embodiments of the present disclosure will be given in part in the following descriptions, become apparent in part from the following descriptions, or be learned from the practice of the embodiments of the present disclosure.

### BRIEF DESCRIPTION OF THE DRAWINGS

These and other aspects and advantages of the disclosure will become apparent and more readily appreciated from the following descriptions taken in conjunction with the drawings in which:
Fig. 1 is a structural block diagram of the internal resistance testing device according to an embodiment of the present disclosure;
Fig. 2 is a flow chat of coarsely adjusting the adjustable resistance in the internal resistance testing method according to an embodiment of the present disclosure;
Fig. 3 is a flow chat of finely adjusting the adjustable resistance in the internal resistance testing method according to an embodiment of the present disclosure;
Fig. 4 is a flow chart of flow C in Fig. 3 ; and
Fig. 5 is a flow chart of the flow D in Fig.3.

### DETAILED DESCRIPTION

Reference will be made in detail to embodiments of the present disclosure. The embodiments described herein with reference to drawings are explanatory, illustrative, and used to generally understand the present disclosure. The embodiments shall not be construed to limit the present disclosure. The same or similar elements and the elements having same or similar functions are denoted by like reference numerals throughout the descriptions.

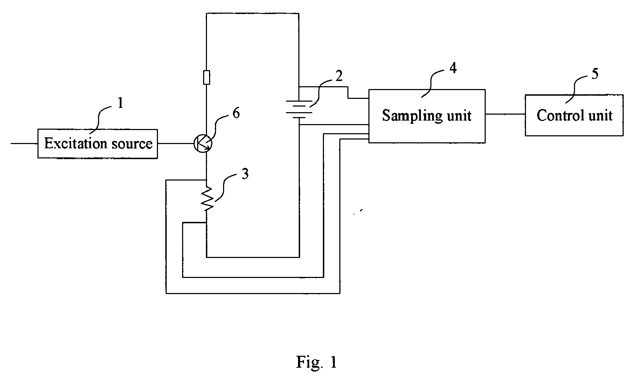

As shown in Fig. 1, an internal resistance testing device for testing an internal resistance of a battery pack comprises an excitation source 1 and a battery pack 2, an adjustable resistance 3, a sampling unit 4 and a control unit 5. The adjustable resistance 3 is connected with the battery pack 2 so as to form a loop circuit. The excitation source 1 is coupled to the loop circuit to apply an excitation to the loop circuit so as to generate an excitation current in the loop circuit. The sampling unit 4 is coupled to the loop circuit and used to collect an excitation voltage *V*₂ between two terminals of the battery pack 2, an excitation voltage *V*₁ between two terminals of the adjustable resistance 3 and a resistance value *R* of the adjustable resistance 3. The control unit 5 is coupled to the sampling unit 4 and used to calculate an internal resistance of the battery pack2 based on the excitation voltage *V*₂, the excitation voltage *V*₁ and the resistance value R of the adjustable resistance 3 which are collected by the sampling unit 4 at a time when the excitation voltage *V*₂ is equal to a range voltage *V*_{(standard)} of the sampling unit 4.

In some embodiments, the excitation source 1 may be an alternating current excitation source to apply an alternating current excitation to the loop circuit.

In some embodiments, as shown in Fig. 1, The internal resistance testing device further comprises a transistor 6 connected in the loop circuit. The excitation source 1 is coupled to a control end of the transistor 6 so that the excitation source 1 may apply the alternating current excitation to the loop circuit via the control end of the transistor 6, so as to generate a sine excitation current in the loop circuit, so that an excitation voltage *V*1 between two terminals of the adjustable resistance and an excitation voltage *V*2 between two terminals of the battery pack 2.

The sampling unit 4 is coupled to the loop circuit and used to collect the excitation voltage *V*2 between two terminals of the battery pack 2, the excitation voltage *V*₁ between two terminals of the adjustable resistance 3 and the resistance value *R* of the adjustable resistance 3. After an alternating current excitation is applied to the loop circuit, excitation voltages between two terminals of the adjustable resistance 3 and between two terminals of the battery pack 2 may be generated respectively. Then the sampling unit 4 may collect excitation voltages between two terminals of the adjustable resistance 3 and between two terminals of the battery pack 1 as well as the resistance value *R* of the adjustable resistance 3. In an embodiment, the sampling unit may be a CS5463 sampling chip.

The control unit 5 may be coupled to the sampling unit 4 to receive the excitation voltage *V*₂, the excitation voltage *V*₁ and the resistance value *R* of the adjustable resistance 3 which are collected by the sampling unit at a time when the excitation voltage *V*₂ is equal to a range voltage *V*_{(standard)} of the sampling unit 4, and calculate the internal resistance of the battery pack 2 based on the excitation voltage *V*₂, the excitation voltage *V*₁ and the resistance value *R* of the adjustable resistance 3. In an embodiment, the control program of the control unit 5 may be integrated into the sampling chip. The battery pack 2 may comprise at least one single cell.

Particularly, the control unit 5 calculates the internal resistance of the battery pack 2 using a formula: *r*=PF × *V*₂/I, in which *r* is the internal resistance of the battery pack 2, *I* is an excitation current in the loop circuit and calculated by using the excitation voltage *V*2 between two terminals of the adjustable resistance 3 and the resistance value *R* of the adjustable resistance, and PF is a power coefficient of the loop circuit.

In some embodiment, the internal resistance testing device may comprises a resistance value adjusting unit coupled to the adjustable resistance 3, the resistance value adjusting unit may coarsely and finely adjust the resistance value *R* of the adjustable resistance 3. For example, the resistance value adjusting unit is controlled to adjust the resistance value *R* of the adjustable resistance 3 by the control unit 5 based on a relationship of the excitation voltage *V*₂ between two terminals of the battery pack 2 with the range voltage *V*_{(stantard)} of the sampling unit 4.

An internal resistance testing method using the internal resistance testing device according to embodiments of the present disclosure will be described below.

The internal resistance testing method comprises the following steps:
a) applying an excitation to the loop circuit by the excitation source 1;
b) collecting an excitation voltage *V*₂ between the two terminals of the battery pack 2, an excitation voltage *V*₁ between the two terminals of the adjustable resistance 3 and the resistance value *R* of the adjustable resistance 3 by the sampling unit 4;
c) adjusting the resistance value *R* of the adjustable resistance 3 to equate the excitation voltage *V*2 between the two terminals of the battery pack 2 with the range voltage *V*_{(standard)} of the sampling unit 4; and
d) calculating an internal resistance r of the battery pack based on the excitation voltage *V*₂, the excitation voltage *V*₁ and the resistance value R which are collected by the sampling unit 4 at a time when the excitation voltage *V*₂ is equal to a range voltage *V*_{(standard)} of the sampling unit 4.

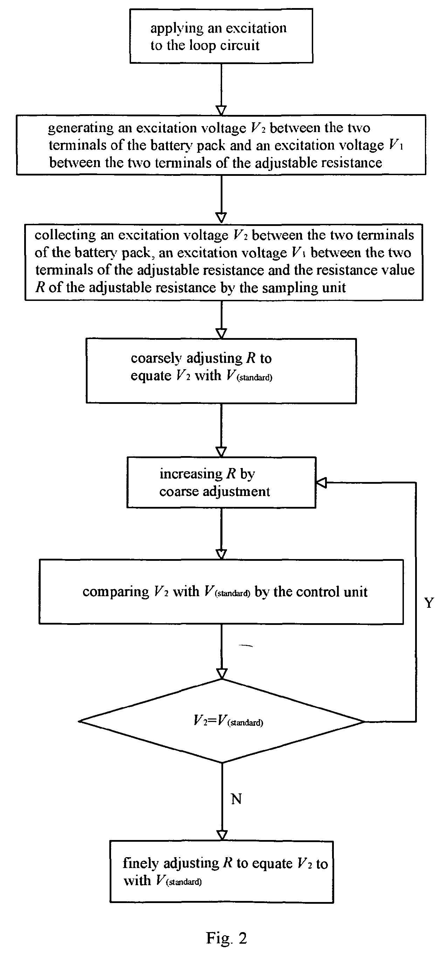

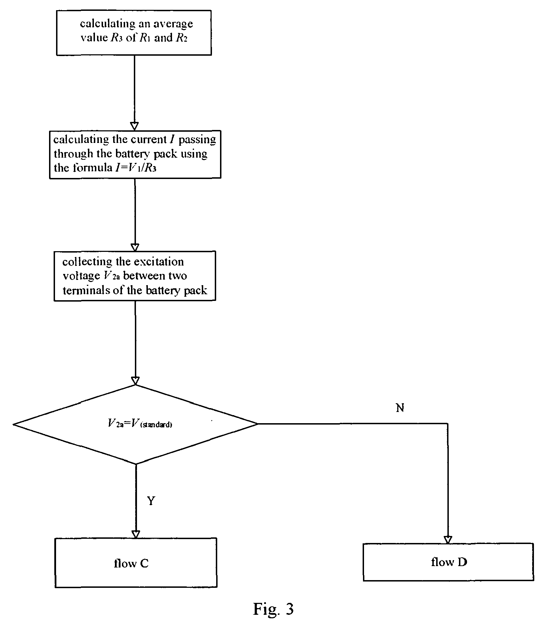

In some particular embodiments of the present disclosure, as shown in Fig. 2 and Fig. 3, firstly, the excitation source may apply an alternating current excitation to the loop circuit formed by the adjustable resistance 3, the battery pack 2 and the transistor 6 via the control end of the transistor 6, so as to generate a sine excitation current in the whole loop circuit, therefore, an excitation voltage *V*₁ is generated between two terminals of the adjustable resistance 3 and an excitation voltage *V*₂ is generated between two terminals of the battery pack 2.

At this time, the sampling unit 4 may collect the excitation voltage *V*₁ between two terminals of the adjustable resistance 3, the excitation voltage *V*₂ between two terminals of the battery pack 2 and the resistance value *R* of the adjustable resistance 3, and send the collected excitation voltage *V*₁, the excitation voltage *V*₂ and the resistance value *R* to the control unit 5.

The resistance value *R* of the adjustable resistance 3 is coarsely adjusted to equate the excitation voltage *V*₂ with the maximum range voltage *V*_{(standard)} of the sampling unit 4, which indicates that a clipping may exist in the waves of the excitation voltage collected by the sampling unit 4.

Then the adjustable resistance 3 is coarsely adjusted to increase the resistance value *R* of the adjustable resistance 3, and the sampling unit 4 may collect the excitation voltage between two terminals of the adjustable resistance3 , the excitation voltage between two terminals of the battery pack 2 and the resistance value *R* of the adjustable resistance, and send the collected the excitation voltage between two terminals of the adjustable resistance 3, the excitation voltage between two terminals of the battery pack 2 and the resistance value *R* of the adjustable resistance 3 to the control unit 5. The control unit 5 may compare the excitation voltage *V*₂ between two terminals of the battery pack 2 with the range voltage *V*_{(standard)}.

If *V*₂=*V*_{(standard)}, that is to say, a clipping may exist in the waves, coarse adjustment of the adjustable resistance 3 is continued to increase the resistance value *R* of the adjustable resistance 3, so that the excitation current in the loop circuit may be decreased. The sampling unit 4 may continuously collect the excitation voltage *V*1 between two terminals of the adjustable resistance 3, the excitation voltage *V*2 between two terminals of the battery pack 2 and the resistance value *R* of the adjustable resistance, and send the collected the excitation voltage *V*1 between two terminals of the adjustable resistance 3, the excitation voltage *V*2 between two terminals of the battery pack 2 and the resistance value *R* of the adjustable resistance 3 to the control unit 5. The control unit 5 may continuously compare the excitation voltage *V*₂ between two terminals of the battery pack 2 with the maximum range voltage *V*_{(standard)} of the sampling unit 4. If *V*₂ is still equal to *V*_{(standard)}, that is to say, a clipping may exist in the waves, the resistance value *R* of the adjustable resistance 3 is continuously increased until *V*₂ is smaller than *V*_{(standard)}.

If *V*₂ is smaller than *V*_{(standard)}, fine adjustment of the adjustable resistance is performed to equate the excitation voltage between two terminals of the battery pack 2 collected by the sampling unit 4 with the maximum range voltage *V*_{(standard)} of the sampling unit 4. The particular fine adjustment process is as follows.

During the coarse adjustment of the adjustable resistance, the control unit 5 records the resistance value of the adjustable resistance, by which the excitation voltage between two terminals of the battery pack 2 is equal to the range voltage *V*_{(standard)} of the sampling unit for the last time, as *R*₁, and then records the resistance value of the adjustable resistance, by which *V2* is smaller than *V*_{(standard)}, as *R*₂. If the critical resistance value *R* of the adjustable resistance is *R*₀ when the actual excitation voltage between two terminals of the battery pack 2 is equal to the maximum range voltage of the sampling unit 4, the *R*₀ is taken in a range of *R*₁ to *R*₂. Therefore the resistance value of the adjustable resistance is finely adjusted in the range of *R*₁ to *R*₂.

In a particular embodiment, *a* is a minimum unit for finely adjusting the adjustable resistance 3, and *m* and *n* are integer variables set in the testing device.

During the fine adjustment, the adjustable resistance is adjusted to equate the resistance value *R* of the adjustable resistance with an average resistance value *R*₃ of *R*₁ and *R*₂. The control unit 5 may calculate the current in the loop circuit using the formula *I*=*V*₁/*R*₃ based on the excitation voltage *V*₁ between two terminals of the adjustable resistance 3 and the resistance value R₃ of the adjustable resistance collected by the sampling unit 4. After collecting the excitation voltage *V*₂ₐ between two terminals of the battery pack 2, the sampling unit 4 may send the excitation voltage *V*₂ₐ to the control unit 5.

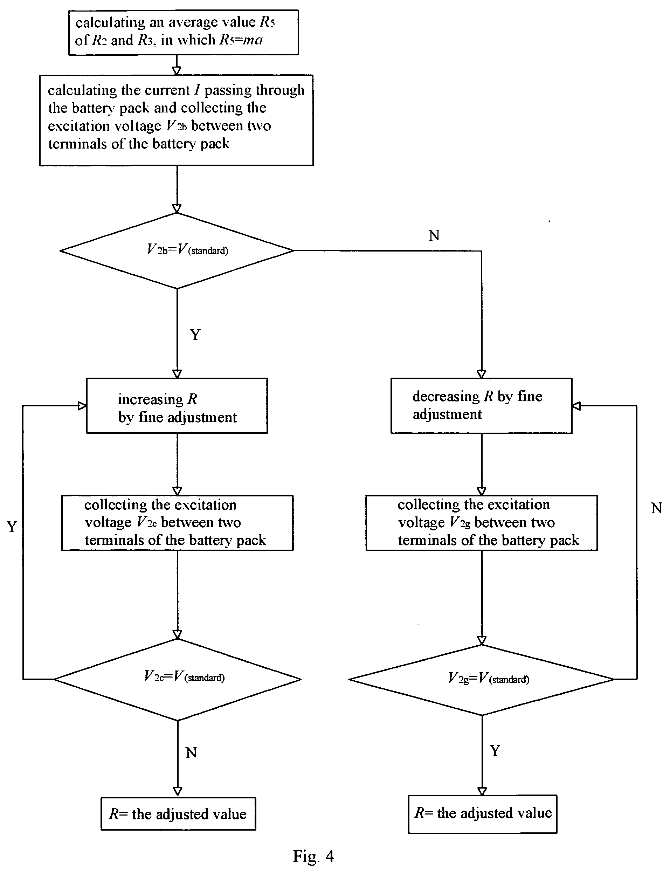

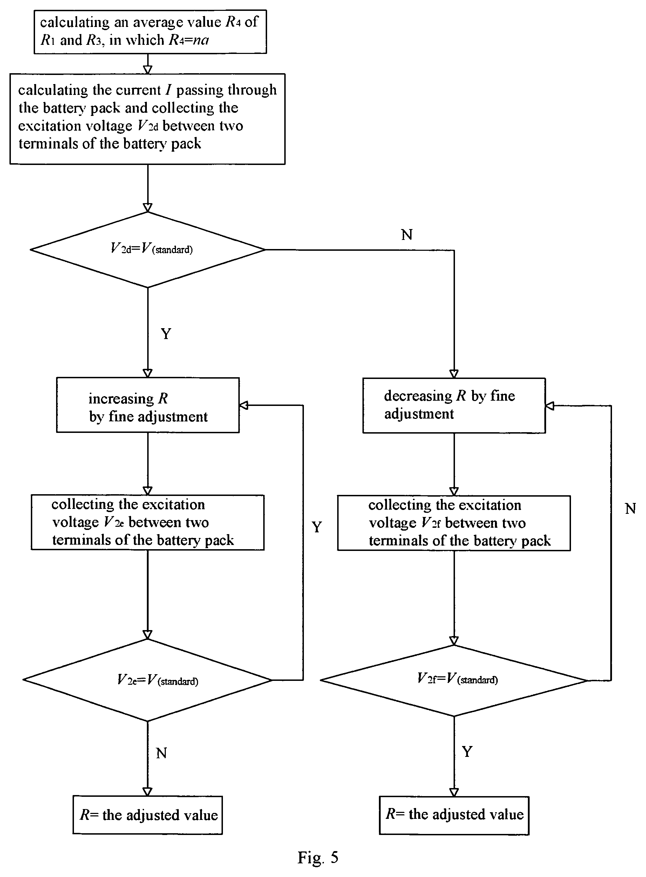

The control unit 5 may compare the excitation voltage *V*₂ₐ between two terminals of the battery pack 2 with *V*_{(standard)}. If the excitation voltage *V*₂ₐ is equal to *V*_{(standard)}, the control unit 5 may control the process of the testing to go into the flow C, as shown in Fig. 4. If the excitation voltage *V*₂ₐ is smaller than *V*_{(standard)}, the control unit 5 may control the process of testing to go into the flow D, as shown in Fig. 5.

As shown in Fig. 4, when the process of the testing enters into flow C, because the excitation voltage *V*₂ₐ between two terminals of the battery pack 2 is equal to *V*_{(standard)}, *R*₃<*R*₀, so that the resistance value *R* of the adjustable resistance 3 needs to be increased. The adjustable resistance is adjusted to equate the resistance value *R* of the adjustable resistance with an average resistance value R₅ of *R*₂ and *R*₃, in which *R₅*=*ma*. The control unit 5 may calculate the current in the loop circuit using the formula *I*=*V*₁/*R*₅ based on the excitation voltage *V*₁ between two terminals of the adjustable resistance 3 and the resistance value R₅ of the adjustable resistance 3 collected by the sampling unit 4, and the excitation voltage *V*_{2b} between two terminals of the battery pack 2 is collected by the sampling unit 4 and sent to the control unit 5. If the excitation voltage *V*_{2b} between two terminals of the battery pack 2 collected by the sampling unit 4 is still equal to *V*_{(standard)}, *R*₅<*R*₀, then keeping on increasing the resistance value *R* of the adjustable resistance 3.

The adjustable resistance is finely adjusted to equate the resistance value *R* of the adjustable resistance 3 with (*m*+1)*a*. The sampling unit 4 may continuously collect the excitation voltage *V*_{2c} between two terminals of the battery pack 2 and send the excitation voltage *V*_{2c} to the control unit 5. If the excitation voltage *V_{2c}* between two terminals of the battery pack 2 collected by the control unit 4 is smaller than *V*_{(standard)} at this moment, the control unit 5 may take the resistance value *R* of the adjustable resistance 3 as *(m+1)a,* that is to say, in order to keep the excitation voltage between two terminals of the battery pack 2 to be equal to *V*_{(standard)}, the resistance value *R* of the adjustable resistance 3 needs to be adjusted to (*m*+1)*a*, so that the internal resistance of the battery pack 3 measured at this moment is most accurate. If the excitation voltage *V*_{2c} between two terminals of the battery pack 2 received by the control unit 5 is equal to *V*_{(standard)}, the resistance value *R* of the adjustable resistance 3 is needed to be continuously increased. The adjustable resistance 3 is finely adjusted to equate the resistance value *R* of the adjustable resistance 3 with (*m*+2)*a*, then the excitation voltage between two terminals of the battery pack 2 is continuously collected. If the excitation voltage between two terminals of the battery pack 2 is smaller than *V*_{(standard)}, the resistance value *R* of the adjustable resistance is finally taken as (*m*+2)*a*, that is to say, when the resistance value *R* of the adjustable resistance is adjusted to (*m*+2)*a*, the measured internal resistance of the battery pack is most accurate. Otherwise, the resistance value of the adjustable resistance is continuously increased by the minimum unit through the fine adjustment, until the resistance value *R* of the adjustable resistance satisfies that the excitation voltage between two terminals of the battery pack is equal to *V*_{(standard)} when *R*=(*m*+*x*-1)*a*, in which *x* is a number of times of fine adjustment, and the excitation voltage between two terminals of the battery pack is smaller than *V*_{(standard)} when *R*=(*m*+*x*)*a*. Therefore, only when the resistance value *R* of the adjustable resistance is adjusted to (*m*+*x*)*a*, the excitation voltage between two terminals of the battery pack is equal to *V*_{(standard)}, and the measured internal resistance of the battery pack at this moment is most accurate.

If the excitation voltage *V*_{2b} between two terminals of the battery pack 2 collected by the sampling unit 4 is smaller than *V*_{(standard)}, *R*₅>*R*₀, so that the resistance value *R* of the adjustable resistance needs to be decreased. The resistance value of the adjustable resistance is finely adjusted to (*m*-1)*a*, and the sampling unit 4 may continuously collect the excitation voltage *V*_{2g} between two terminals of the battery pack and send the excitation voltage *V*_{2g} to the control unit 5. If the excitation voltage *V*_{2g} of the battery pack 2 received by the control unit 5 is equal to *V*_{(standard)} when the resistance value of the adjustable resistance is (*m*-1*)a*, the control unit 5 may take the resistance value *R* of the adjustable resistance as (*m*-1)*a*, that is to say, in order to equate the excitation voltage between two terminals of the battery pack 2 with *V*_{(standard)}, the resistance value of the adjustable resistance 3 needs to be adjusted to (*m*-1)*a*, so that the internal resistance of the battery pack measured at this moment is most accurate. If the excitation voltage *V*_{2g} of the battery pack received by the control unit 5 is smaller than *V*_{(standard)}, the resistance value *R* of the adjustable resistance 3 is continuously decreased. The adjustable resistance is finely adjusted to equate the resistance value of the adjustable resistance with *(m-2)a,* then the excitation voltage between two terminals of the battery pack is continuously collected. If the excitation voltage between two terminals of the battery pack 2 is equal to *V*_{(standard)} when the resistance value of the adjustable resistance is (*m*-2)*a*, the adjustable resistance is taken as (*m*-2)*a*, that is to say, when the adjustable resistance is adjusted to (*m*-2)*a*, the measured internal resistance of the battery pack is most accurate. Otherwise, the resistance value *R* of the adjustable resistance is continuously decreased by the minimum unit through the fine adjustment, until the resistance value *R* of the adjustable resistance satisfies that the excitation voltage between two terminals of the battery pack is equal to *V*_{(standard)} when *R*=(*m*-*z*-1)*a*, in which z is a number of times of fine adjustment, and the excitation voltage between two terminals of the battery pack is smaller than *V*_{(standard)} when *R*=(*m*-*z*)*a*. So that only when the resistance value *R* of the adjustable resistance 3 is adjusted to (*m*-*z*-1)*a*, the excitation voltage between two terminals of the battery pack is equal to *V*_{(standard)}, and the internal resistance of the battery pack measured at this moment is most accurate.

As shown in Fig. 5, when the process of testing enters into flow D, because the excitation voltage *V*₂ₐ between two terminals of the battery pack is smaller than *V*_{(standard)} at this moment , *R*₃>*R*₀, so that the resistance value *R* of the adjustable resistance 3 needs to be decreased. The adjustable resistance is adjusted to equate the resistance value *R* of the adjustable resistance with an average resistance value R₄ of *R*₁ and *R*₃, in which *R*₄=*na*. The control unit 5 may calculate the current in the loop circuit using the formula *I*=*V*₁/*R*₄ based on the excitation voltage *V*₁ between two terminals of the adjustable resistance and the resistance value R₄ of the adjustable resistance collected by the sampling unit 4, and the excitation voltage *V*_{2d} between two terminals of the battery pack is collected by the sampling unit 4 and sent to the control unit 5. If the excitation voltage *V*_{2d} between two terminals of the battery pack collected by the sampling unit 4 is still smaller than *V*_{(standard)}, *R*₃>*R*₀, it is needed to keeping on decreasing the resistance value *R* of the adjustable resistance 3.

The resistance value of the adjustable resistance is finely adjusted to *(n-1)a,* and the sampling unit 4 may continuously collect the excitation voltage *V*_{2f} between two terminals of the battery pack 2 and send the excitation voltage *V*_{2f} to the control unit 5. If the excitation voltage *V*_{2f} of the battery pack received by the control unit 5 is equal to *V*_{(standard)} when the resistance value of the adjustable resistance is equal to *(n-1)a,* the control unit 5 may take the resistance value *R* of the adjustable resistance as (*n*-1)*a*, that is to say, in order to equate the excitation voltage between two terminals of the battery pack with *V*_{(standard}), the resistance value of the adjustable resistance needs to be adjusted to *(n-1)a,* so that the internal resistance of the battery pack measured at this moment is most accurate. If the excitation voltage *V*_{2f} of the battery pack received by the control unit 5 is smaller than *V*_{(standard)}, the resistance value *R* of the adjustable resistance is needed to be continuously decreased. The adjustable resistance 3 is finely adjusted to equate the resistance value of the adjustable resistance with *(n-2)a,* then the excitation voltage between two terminals of the battery pack is continuously collected. If the excitation voltage between two terminals of the battery pack is equal to *V*_{(standard)} when the resistance value is equal to *(n-2)a,* the adjustable resistance is finally taken as *(n-2)a,* that is to say, when the adjustable resistance is adjusted to *(n-2)a,* the measured internal resistance of the battery pack is most accurate. Otherwise, the resistance value *R* of the adjustable resistance is continuously decreased by the minimum unit through the fine adjustment until the resistance value *R* of the adjustable resistance satisfies that the excitation voltage between two terminals of the battery pack is equal to *V*_{(standard)} when *R*=(*n*-*y*-*1*)*a*, in which y is a number of times of fine adjustment, and the excitation voltage between two terminals of the battery pack is smaller than *V*_{(standard)} when *R*=(*n*-*y*)*a*. So that only when the resistance value *R* of the adjustable resistance is adjusted to (*n*-*y*-1)*a*, the excitation voltage between two terminals of the battery pack is equal to *V*_{(standard)}, and the internal resistance of the battery pack measured at this moment is most accurate.

If the excitation voltage *V*_{2d} between two terminals of the battery pack collected by the sampling unit 4 is equal to *V*_{(standard)}, *R*₃<*R*₀, so that the resistance value *R* of the adjustable resistance needs to be increased. The adjustable resistance is finely adjusted to equate the resistance value *R* of the adjustable resistance with (*n*+1)*a*. The sampling unit 4 may continuously collect the excitation voltage *V*₂ₑ between two terminals of the battery pack and send the excitation voltage *V*₂ₑ to the control unit 5. If the excitation voltage *V*₂ₑ between two terminals of the battery pack received by the control unit 5 is smaller than *V*_{(standard)} when the resistance value *R* of the adjustable resistance is equal to (*n*+1)*a*, the control unit 5 may take the resistance value *R* of the adjustable resistance as (*n*+1)*a*, that is to say, in order to equate the excitation voltage between two terminals of the battery pack with *V*_{(standard)}, the resistance value *R* of the adjustable resistance needs to be adjusted to (*n*+1)*a*, so that the internal resistance of the battery pack measured at this moment is most accurate. If the excitation voltage *V₂ₑ* between two terminals of the battery pack received by the control unit 5 is equal to *V*_{(standard)}, the resistance value *R* of the adjustable resistance is needed to be continuously increased. The adjustable resistance is finely adjusted to equate the resistance value *R* of the adjustable resistance with (*n*+2)*a*, then the excitation voltage between two terminals of the battery pack is continuously collected. If the excitation voltage between two terminals of the battery pack is smaller than *V*_{(standard)}, the resistance value *R* of the adjustable resistance is finally taken as (*n*+2)*a*, that is to say, when the resistance value *R* of the adjustable resistance is adjusted to (*n*+2)*a*, the measured internal resistance of the battery pack is most accurate. Otherwise, the resistance value of the adjustable resistance is continuously adjusted by the minimum unit through the fine adjustment until the resistance value *R* of the adjustable resistance satisfies that the excitation voltage between two terminals of the battery pack is equal to *V*_{(standard)} when *R*=(*n*+*w*-1)*a*, in which w is a number of times of fine adjustment, and the excitation voltage between two terminals of the battery pack is smaller than *V*_{(standard)} when *R*=(*n*+*w*)*a*. So that only when the resistance value *R* of the adjustable resistance is adjusted to (*n*+*w*)*a*, the internal resistance of the battery pack measured at this moment is most accurate.

After the coarse and fine adjustment of the adjustable resistance, the control unit 5 may calculate the current in the loop circuit using the formula *I=V*₁/*R* based on the excitation voltage *V*₁ between two terminals of the adjustable resistance. Then the control unit 5 may calculate the internal resistance based on the excitation voltage *V*₂ between two terminals of the battery pack collected by the sampling unit 4 and the current *I* in the loop circuit. During applying the alternating current excitation, there is a phase difference between the excitation voltage and the excitation current, i.e. the power coefficient PF, so that the internal resistance of the battery pack *r*=*PF*×*V*₂*lI*, in which the power coefficient PF may be calculated by the control unit 5, which is well known in the art and detailed description thereof is omitted here.

In the above embodiments, the resistance value of the adjustable resistance may be adjusted manually or under control of inner program, for example the resistance value *R* of the adjustable resistance may be adjusted coarsely and finely by the resistance value adjusting unit.

Although explanatory embodiments have been shown and described, it would be appreciated by those skilled in the art that changes, alternatives, and modifications can be made in the embodiments without departing from principles of the disclosure. Such changes, alternatives, and modifications all fall into the scope of the claims and their equivalents.

According to further embodiments of the present invention the following exemplary embodiments are provided. These exemplary embodiments are denoted as examples "E".
E1. An internal resistance testing device, comprising:
   a battery pack;
   an adjustable resistance connected with the battery pack to form a loop circuit;
   an excitation source coupled to the loop circuit to apply an excitation to the loop circuit so as to generate an excitation current in the loop circuit;
   a sampling unit coupled to the loop circuit and used to collect an excitation voltage *V*₂ between two terminals of the battery pack, an excitation voltage *V*₁ between two terminals of the adjustable resistance and a resistance value *R* of the adjustable resistance; and
   a control unit coupled to the sampling unit and used to calculate an internal resistance of the battery pack based on the excitation voltage *V*₂, the excitation voltage *V*₁ and the resistance value R which are collected by the sampling unit at a time when the excitation voltage *V*₂ is substantially equal to a range voltage *V*_{(standard)} of the sampling unit.
E2. The device according to E1, wherein the sampling unit is a CS5463 sampling chip.
E3. The device according to E1, wherein the excitation source is an alternating current excitation source.
E4. The device according to E1, further comprising a transistor connected in the loop circuit, in which the excitation source is coupled to a control end of the transistor to apply the excitation to the loop circuit via the transistor.
E5. The device according to E1, wherein the control unit calculates the internal resistance of the battery pack using a formula: *r*=PF×*V*₂/*I*, in which *r* is the internal resistance of the battery pack, *I* is an excitation current in the loop circuit and calculated by using the excitation voltage *V2* between two terminals of the adjustable resistance and the resistance value *R* of the adjustable resistance, and PF is a power coefficient of the loop circuit.
E6. The device according to E1, further comprising:
   a resistance value adjusting unit coupled to the adjustable resistance and used to coarsely and finely adjust the resistance value *R* of the adjustable resistance.
E7. The device according to E6, wherein the resistance value adjusting unit is controlled to adjust the resistance value *R* of the adjustable resistance by the control unit based on a relationship of the excitation voltage *V*₂ between two terminals of the battery pack with the range voltages. *V*_{(standard)} of the sampling unit.
E8. An internal resistance testing method using the internal resistance testing device according to E1, comprising steps of:
   a) applying an excitation to the loop circuit by the excitation source;
   b) collecting an excitation voltage *V*₂ between the two terminals of the battery pack, an excitation voltage *V*₁ between the two terminals of the adjustable resistance and the resistance value *R* of the adjustable resistance by the sampling unit;
   c) adjusting the resistance value *R* of the adjustable resistance to equate the excitation voltage *V*2 between the two terminals of the battery pack with the range voltage *V*_{(standard)} of the sampling unit; and
   d) calculating an internal resistance *r* of the battery pack based on the excitation voltage *V*₂, the excitation voltage *V*₁ and the resistance value R which are collected at a time when the excitation voltage *V*₂ is substantially equal to a range voltage *V*_{(standard)} of the sampling unit.
E9. The method according to E8, wherein step c) comprises:
   coarsely adjusting the resistance value *R* of the adjustable resistance until the excitation voltage *V*₂ between two terminals of the battery pack collected by the sampling unit is substantially equal to the range voltage *V*_{(standard)} of the sampling unit;
   increasing the resistance value *R* of the adjustable resistance until the excitation voltage *V2* between two terminals of the battery pack collected by the sampling unit is smaller than the range voltage *V*_{(standard)} of the sampling unit, and recording the resistance value of the adjustable resistance at this time as *R*₂;
   recording the resistance value of the adjustable resistance, by which the excitation voltage *V2* between two terminals of the battery pack is substantially equal to the range voltage *V*_{(standard)} of the sampling unit for the last time, as *R*₁;
   finely adjusting the adjustable resistance to substantially equate the excitation voltage *V*2 between two terminals of the battery pack with the range voltage of the sampling unit; and
   calculating the internal resistance of the battery pack based on the excitation voltage *V*₁ between two terminals of the adjustable resistance, the resistance value *R* of the adjustable resistance and the excitation voltage *V*₂ between two terminals of the battery pack which are collected at a time when the adjustable resistance is finely adjusted to substantially equate the excitation voltage *V2* between two terminals of the battery pack with the range voltage *V*_{(standard)} of the sampling unit.
E10. The method according to E9, wherein finely adjusting the adjustable resistance comprises:
   adjusting the adjustable resistance to equate the resistance value *R* of the adjustable resistance with an average resistance value R₃ of *R*₁ and *R*₂;
   collecting the excitation voltage *V*₂ₐ between two terminals of the battery pack when the resistance value *R* of the adjustable resistance is equal to the average resistance value R₃; and
   adjusting the resistance value *R* of the adjustable resistance based on the excitation voltage between two terminals of the battery pack and the range voltage *V*_{(standard)} of the sampling unit.
E11. The method according to E10, wherein adjusting the resistance value *R* of the adjustable resistance based on the excitation voltage *V*₂ₐ between two terminals of the battery pack and the range voltage *V*_{(standard)} of the sampling unit comprises:
   if the excitation voltage *V*₂ₐ between two terminals of the battery pack is equal to *V*_{(standard)},
   adjusting the adjustable resistance to equate the resistance value *R* of the adjustable resistance with an average resistance value R₅ of *R*₂ and *R*₃, in which *R*₅=*ma*, where *m* is an integer variable set in the testing device, and a is a minimum unit for finely adjusting the adjustable resistance;
   collecting the excitation voltage *V*_{2b} between two terminals of the battery pack when the resistance value *R* is equal to average resistance value R₅ ; and
   keeping on adjusting the resistance value *R* of the adjustable resistance based on the excitation voltage *V*_{2b} between two terminals of the battery pack and the range voltage *V*_{(standard)} of the sampling unit.
E12. The method according to E11, wherein keeping on adjusting the resistance value *R* of the adjustable resistance based on the excitation voltage *V*_{2b} between two terminals of the battery pack and the range voltage *V*_{(standard)} of the sampling unit further comprises:
   if the excitation voltage *V*_{2b} between two terminals of the battery pack is equal to *V*_{(standard)},
   adjusting the adjustable resistance to equate the resistance value *R* of the adjustable resistance with (*m*+1)*a*;
   determining whether the excitation voltage *V*_{2c} between two terminals of the battery pack is smaller than *V*_{(standard)} when the resistance value *R* of the adjustable resistance is equal to (*m*+1)*a*; and
   if *V*_{2c}<*V*_{(standard)}, taking the resistance value *R* of the adjustable resistance as (*m*+1)*a*, and calculating the internal resistance of the battery pack based on the excitation voltage between two terminals of the battery pack, the excitation voltage between two terminals of the adjustable resistance and the resistance value of the adjustable resistance which are collected by the sampling unit at a time when *V*_{2c}<*V*_{(standard)} and the resistance value *R* of the adjustable resistance is taken as (*m*+1)*a*.
E13. The method according to E12, further comprising:
   if *V*_{2c}=*V*_{(standard)}, keeping on adjusting the resistance value *R* of the adjustable resistance; and
   when the resistance value *R* of the adjustable resistance satisfies that the excitation voltage between two terminals of the battery pack is equal to *V*_{(standard)} when *R*=(*m*+*x*-1)*a*, in which *x* is a number of times of fine adjustment, and the excitation voltage between two terminals of the battery pack is smaller than *V*_{(standard)} when *R*=(*m*+*x*)*a*, taking the resistance value *R* of the adjustable resistance as (*m*+*x*)*a*, and calculating the internal resistance of the battery pack based on the excitation voltage between two terminals of the battery pack, the excitation voltage between two terminals of the adjustable resistance and the resistance value of the adjustable resistance which are collected by the sampling unit at a time when *V*_{2c}= *V*_{(standard)} and the resistance value *R* of the adjustable resistance is taken as (*m*+*x*)*a*.
E14. The method according to E11, wherein keeping on adjusting the resistance value of the adjustable resistance based on the excitation voltage *V*_{2b} between two terminals of the battery pack and the range voltage *V*_{(standard)} of the sampling unit further comprises:
   if the excitation voltage *V*_{2b} between two terminals of the battery pack is smaller than *V*_{(standard)} of the sampling unit,
   keeping on adjusting the adjustable resistance to equate the resistance value *R* of the adjustable resistance with (*m*-1)*a*;
   determining whether the excitation voltage *V*_{2g} between two terminals of the battery pack is equal to *V*_{(standard)} when the resistance value *R* of the adjustable resistance is equal to (*m*-1)*a*; and
   if *V*_{2g}=*V*_{(standard)}, taking the adjustable resistance as (*m*-1)*a*, and calculating the internal resistance of the battery pack based on the excitation voltage between two terminals of the battery pack, the excitation voltage between two terminals of the adjustable resistance and the resistance value of the adjustable resistance which are collected by the sampling unit at a time when *V*_{2g}=*V*_{(standard)} and the resistance value *R* is taken as (*m*-1)*a*.
15. The method according to claim 14, further comprising:
   if *V*₂ₐ<*V*_{(standard)}, keeping on adjusting the resistance value *R* of the adjustable resistance; and
   When the resistance value *R* of the adjustable resistance satisfies that the excitation voltage between two terminals of the battery pack is equal to *V*_{(standard)} when *R*=(*m*-*z*-1)*a*, in which *z* is a number of times of fine adjustment, and the excitation voltage between two terminals of the battery pack is smaller than *V*_{(standard)} when *R*=(*m*-*z*)*a*, taking the resistance value *R* of the adjustable resistance as (*m*-*z*-1)*a*, and calculating the internal resistance of the battery pack based on the excitation voltage between two terminals of the battery pack, the excitation voltage between two terminals of the adjustable resistance and the resistance value of the adjustable resistance which are collected by the sampling unit at a time when *V*_{2g}<*V*_{(standard)} and the resistance value *R* of the adjustable resistance is taken as (*m*-*z*-1*)a.*
E16. The method according to E10, wherein adjusting the resistance value of the adjustable resistance based on the excitation voltage *V*₂ₐ, between two terminals of the battery pack and the range voltage *V*_{(Standard)} of the sampling unit comprises:
   if the excitation voltage *V*₂ₐ between two terminals of the battery pack is smaller than *V*_{(standard)},
   adjusting the adjustable resistance to equate the resistance value *R* of the adjustable resistance with an average resistance value R₄ of *R*₁ and *R*₃, in which *R*₄=*n*a, where *n* is an integer variable set in the testing device, and *a* is a minimum unit for finely adjusting the adjustable resistance;
   collecting the excitation voltage *V*_{2d} between two terminals of the battery pack; and
   keeping on adjusting the resistance value *R* of the adjustable resistance based on the excitation voltage *V*_{2d} between two terminals of the battery pack and the range voltage *V*_{(stdndard)} of the sampling unit.
E17. The method according to E16, wherein keeping on adjusting the resistance value of the adjustable resistance based on the excitation voltage *V*_{2d} between two terminals of the battery pack and the range voltage *V*_{(standard)} of the sampling unit further comprises:
   if the excitation voltage *V*_{2d} between two terminals of the battery pack is equal to *V*_{(standard)},
   adjusting the adjustable resistance to equate the resistance value *R* of the adjustable resistance with (*n*+1)*a*;
   determining whether the excitation voltage *V*₂ₑ between two terminals of the battery pack is smaller than *V*_{(standard)} when the resistance value *R* of the adjustable resistance is equal to (*n*+1)*a*; and
   if *V*₂ₑ<*V*_{(standard)}, taking the adjustable resistance as (*n*+1)*a*, and calculating the internal resistance of the battery pack based on the excitation voltage between two terminals of the battery pack, the excitation voltage between two terminals of the adjustable resistance and the resistance value of the adjustable resistance which are collected by the sampling unit at a time when *V*₂ₑ<*V*_{(standard)} and the resistance value *R* of the adjustable resistance is taken as (*n*+1)*a*.
E 18. The method according to E17, further comprising:
   if *V*₂ₑ=*V*_{(standard)}, keeping on adjusting the resistance value *R* of the adjustable resistance; and
   when the resistance value *R* of the adjustable resistance satisfies that the excitation voltage between two terminals of the battery pack is equal to *V*_{(standard)} when *R*=(*n*+*w*-1)*a*, in which *w* is a number of times of fine adjustment, and the excitation voltage between two terminals of the battery pack is smaller than *V*_{(standard)} when *R*=(*n*+*w*)*a*, taking the resistance value of the adjustable resistance as (*n*+*w*)*a*, and calculating the internal resistance of the battery pack based on the excitation voltage between two terminals of the battery pack, the excitation voltage between two terminals of the adjustable resistance and the resistance value of the adjustable resistance which are collected by the sampling unit at a time when *V*₂ₑ=*V*_{(standard)} and the resistance value *R* of the adjustable resistance is taken as (*n*+*w*)*a*.
E19. The method according to E16, wherein keeping on adjusting the resistance value of the adjustable resistance based on the excitation voltage *V*_{2d} between two terminals of the battery pack and the range voltage *V*_{(standard)} of the sampling unit further comprises:
   if the excitation voltage *V*_{2d} between two terminals of the battery pack collected by the sample unit is smaller than *V*_{(standard)},
   adjusting the adjustable resistance to equate the resistance value *R* of the adjustable resistance with (*n*-1)*a*;
   determining whether the excitation voltage *V*_{2f} between two terminals of the battery pack is equal to *V*_{(standard)} when the resistance value *R* of the adjustable resistance to be equal to (*n*-1)*a*; and
   if *V*_{2f}=*V*_{(standard)}, taking the resistance value *R* of the adjustable resistance as *(n-1)a,* and calculating the internal resistance of the battery pack based on the excitation voltage between two terminals of the battery pack, the excitation voltage between two terminals of the adjustable resistance and the resistance value of the adjustable resistance which are collected by the sampling unit at a time when *V*_{2f}=*V*_{(standard)} and the resistance value *R* of the adjustable resistance is taken as (*n*-1)*a*.
E20. The method according to E19, further comprising:
   if *V*_{2f}<*V*_{(standard)}, keeping on adjusting the resistance value *R* of the adjustable resistance; and
   when the resistance value *R* of the adjustable resistance satisfies that the excitation voltage between two terminals of the battery pack is equal to *V*_{(standard)} when *R*=(*n*-*y*-1)*a*, in which y is a number of times of fine adjustment, and the excitation voltage between two terminals of the battery pack is smaller than *V*_{(standard)} when *R*=(*n*-*y*)*a*, taking the resistance value of the adjustable resistance as (*n*-*y*-1)*a*, and calculating the internal resistance of the battery pack based on the excitation voltage between two terminals of the battery pack, the excitation voltage between two terminals of the adjustable resistance and the resistance value of the adjustable resistance which are collected by the sampling unit at a time when the resistance value *R* of the adjustable resistance is taken as (*n*-*y*-1)*a*.
E21. The method according to E8, wherein the internal resistance of the battery pack is calculated by the control unit using a formula: *r*=PF×*V*₂/*I*, in which *I* is the excitation current in the loop circuit and is calculated by the excitation voltage between two terminals of the adjustable resistance and the resistance value of the adjustable resistance, and PF is a power coefficient of the loop circuit.

## Claims

1. An internal resistance testing device, comprising:
a battery pack (2),
an adjustable resistance (3) connected with the battery pack (2) to form a loop circuit;
an excitation source (11) coupled to the loop circuit to apply an excitation to the loop circuit so as to generate an excitation current in the loop circuit;
a sampling unit (4) coupled to the loop circuit and used to collect an excitation voltage *V*₂ between two terminals of the battery pack (2), an excitation voltage *V*₁ between two terminals of the adjustable resistance (3) and a resistance value *R* of the adjustable resistance (3), and
a control unit (5) coupled to the sampling unit (4) and used to calculate an internal resistance of the battery pack (2) based on the excitation voltage *V*₂, the excitation voltage *V*₁ and the resistance value R which are collected by the sampling unit (4) at a time when the excitation voltage *V*₂ is substantially equal to a range voltage *V*_{(standard)} of the sampling unit (4).

2. The device according to claim 1, wherein either
i) the sampling unit is a CS5463 sampling chip; or
ii) the excitation source is an alternating current excitation source; or
iii) the device further comprises a transistor connected in the loop circuit, in which the excitation source is coupled to a control end of the transistor to apply the excitation to the loop circuit via the transistor.

3. The device according to claim 1, wherein the control unit calculates the internal resistance of the battery pack using a formula: *r*=PF × *V*₂/*I*, in which *r* is the internal resistance of the battery pack. *I* is an excitation current in the loop circuit and calculated by using the excitation voltage *V*2 between two terminals of the adjustable resistance and the resistance value *R* of the adjustable resistance, and PF is a power coefficient of the loop circuit.

4. The device according to claim 1, further comprising:
a resistance value adjusting unit coupled to the adjustable resistance and used to coarsely and finely adjust the resistance value *R* of the adjustable resistance.

5. The device according to claim 4, wherein the resistance value adjusting unit is controlled to adjust the resistance value *R* of the adjustable resistance by the control unit based on a relationship of the excitation voltage *V*₂ between two terminals of the battery pack with the range voltage *V*_{(standard)} of the sampling unit.

6. An internal resistance testing method using the internal resistance testing device according to claim 1, comprising steps of:
a) applying an excitation to the loop circuit by the excitation source (1);
b) collecting an excitation voltage *V*₂ between the two terminals of the battery pack (2), an excitation voltage *V*₁ between the two terminals of the adjustable resistance (3) and the resistance value *R* of the adjustable resistance (3) by the sampling unit (4);
c) adjusting the resistance value *R* of the adjustable resistance (3) to equate the excitation voltage *V2* between the two terminals of the battery pack (2) with the range voltage *V*_{(standard)} of the sampling unit (4); and
d) calculating an internal resistance *r* of the battery pack based on the excitation voltage *V*₂, the excitation voltage *V*₁ and the resistance value R which are collected at a time when the excitation voltage *V*₂ is substantially equal to a range voltage *V*_{(standard)} of the sampling unit (4).

7. The method according to claim 6, wherein step c) comprises:
coarsely adjusting the resistance value *R* of the adjustable resistance until the excitation voltage *V2* between two terminals of the battery pack collected by the sampling unit is substantially equal to the range voltage *V*_{(standard)} of the sampling unit;
increasing the resistance value *R* of the adjustable resistance until the excitation voltage *V2* between two terminals of the battery pack collected by the sampling unit is smaller than the range voltage *V*_{(standard)} of the sampling unit, and recording the resistance value of the adjustable resistance at this time as *R*₂;
recording the resistance value of the adjustable resistance, by which the excitation voltage *V2* between two terminals of the battery pack is substantially equal to the range voltage *V*_{(standard)} of the sampling unit for the last time, as *R*₁;
finely adjusting the adjustable resistance to substantially equate the excitation voltage *V*2 between two terminals of the battery pack with the range voltage of the sampling unit; and
calculating the internal resistance of the battery pack based on the excitation voltage *V*₁ between two terminals of the adjustable resistance, the resistance value *R* of the adjustable resistance and the excitation voltage *V*₂ between two terminals of the battery pack which are collected at a time when the adjustable resistance is finely adjusted to substantially equate the excitation voltage *V*₂ between two terminals of the battery pack with the range voltage *V*_{(standard)} of the sampling unit.

8. The method according to claim 7, wherein finely adjusting the adjustable resistance comprises:
adjusting the adjustable resistance to equate the resistance value *R* of the adjustable resistance with an average resistance value R₃ of *R*₁ and *R*₂;
collecting the excitation voltage *V*₂ₐ between two terminals of the battery pack when the resistance value *R* of the adjustable resistance is equal to the average resistance value R₃; and
adjusting the resistance value *R* of the adjustable resistance based on the excitation voltage *V*₂ₐ between two terminals of the battery pack and the range voltage *V*_{(standard)} of the sampling unit.

9. The method according to claim 8, wherein adjusting the resistance value *R* of the adjustable resistance based on the excitation voltage *V*₂ₐ between two terminals of the battery pack and the range voltage *V*_{(standard)} of the sampling unit comprises:
if the excitation voltage *V*₂ₐ between two terminals of the battery pack is equal to *V*(_{standard}),
adjusting the adjustable resistance to equate the resistance value *R* of the adjustable resistance with an average resistance value R₅ of *R*₂ and *R*₃, in which *R₅*=*ma*, where *m* is an integer variable set in the testing device, and *a* is a minimum unit for finely adjusting the adjustable resistance;
collecting the excitation voltage *V*_{2b} between two terminals of the battery pack when the resistance value *R* is equal to average resistance value R₅ ; and
keeping on adjusting the resistance value *R* of the adjustable resistance based on the excitation voltage *V*_{2b} between two terminals of the battery pack and the range voltage *V*_{(standard)} of the sampling unit.

10. The method according to claim 9, wherein keeping on adjusting the resistance value *R* of the adjustable resistance based on the excitation voltage *V*_{2b} between two terminals of the battery pack and the range voltage *V*_{(standard)} of the sampling unit further comprises either one of:
i) if the excitation voltage *V*_{2b} between two terminals of the battery pack is equal to *V*_{(standard)},
adjusting the adjustable resistance to equate the resistance value *R* of the adjustable resistance with (*m* + 1)*a*;
determining whether the excitation voltage *V*_{2c} between two terminals of the battery pack is smaller than *V*_{(standard)} when the resistance value *R* of the adjustable resistance is equal to (*m* + 1)*a*; and
if *V*_{2c}<*V*_{(standard)}, taking the resistance value *R* of the adjustable resistance as (*m* + 1)*a*, and calculating the internal resistance of the battery pack based on the excitation voltage between two terminals of the battery pack, the excitation voltage between two terminals of the adjustable resistance and the resistance value of the adjustable resistance which are collected by the sampling unit at a time when *V*_{2c}<*V*_{(standard)} and the resistance value *R* of the adjustable resistance is taken as (*m*+1)*a*;
or
ii) if the excitation voltage *V*_{2b} between two terminals of the battery pack is smaller than *V*_{(standard)} of the sampling unit,
keeping on adjusting the adjustable resistance to equate the resistance value *R* of the adjustable resistance with (*m*-1)*a*;
determining whether the excitation voltage *V*_{2g} between two terminals of the battery pack is equal to *V*_{(standard)} when the resistance value *R* of the adjustable resistance is equal to (*m*- 1)*a*; and
if *V*_{2g}=*V*_{(standard)}, taking the adjustable resistance as (*m*-1)*a*, and calculating the internal resistance of the battery pack based on the excitation voltage between two terminals of the battery pack, the excitation voltage between two terminals of the adjustable resistance and the resistance value of the adjustable resistance which are collected by the sampling unit at a time when *V*_{2g}=*V*_{(standard)} and the resistance value *R* is taken as (*m*-1)*a*.

11. The method according to claim 10, further comprising either one of:
in case i):
if *V*_{2c}=*V*_{(standard)}, keeping on adjusting the resistance value *R* of the adjustable resistance; and
when the resistance value *R* of the adjustable resistance satisfies that the excitation voltage between two terminals of the battery pack is equal to *V*_{(standard)} when *R*=(*m*+*x*-1)*a*, in which *x* is a number of times of fine adjustment, and the excitation voltage between two terminals of the battery pack is smaller than *V*_{(standard)} when *R*=(*m*+*x*)*a*, taking the resistance value *R* of the adjustable resistance as (*m*+*x*)*a*, and calculating the internal resistance of the battery pack based on the excitation voltage between two terminals of the battery pack, the excitation voltage between two terminals of the adjustable resistance and the resistance value of the adjustable resistance which are collected by the sampling unit at a time when *V*_{2c}=*V*_{(standard)} and the resistance value *R* of the adjustable resistance is taken as (*m*+*x*)*a*.
or
in case ii):
if *V*_{2g}<*V*_{(standard)}, keeping on adjusting the resistance value *R* of the adjustable resistance; and
when the resistance value *R* of the adjustable resistance satisfies that the excitation voltage between two terminals of the battery pack is equal to *V*_{(standard)} when *R*=(*m*-*z*-1)*a*, in which *z* is a number of times of fine adjustment, and the excitation voltage between two terminals of the battery pack is smaller than *V*_{(standard)} when *R*=(*m*-*z*)*a*, taking the resistance value *R* of the adjustable resistance as (*m*-*z*-1)*a*, and calculating the internal resistance of the battery pack based on the excitation voltage between two terminals of the battery pack, the excitation voltage between two terminals of the adjustable resistance and the resistance value of the adjustable resistance which are collected by the sampling unit at a time when *V*_{2g}<*V*_{(standard)} and the resistance value R of the adjustable resistance is taken as (*m*-*z*-1)*a*.

12. The method according to claim 8, wherein adjusting the resistance value of the adjustable resistance based on the excitation voltage *V*₂ₐ between two terminals of the battery pack and the range voltage *V*_{(standard)} of the sampling unit comprises:
if the excitation voltage *V*₂ₐ between two terminals of the battery pack is smaller than *V*_{(standard)},
adjusting the adjustable resistance to equate the resistance value *R* of the adjustable resistance with an average resistance value R₄ of *R*₁ and *R*₃, in which *R*₄=*na*, where *n* is an integer variable set in the testing device, and *a* is a minimum unit for finely adjusting the adjustable resistance;
collecting the excitation voltage *V*_{2d} between two terminals of the battery pack; and
keeping on adjusting the resistance value *R* of the adjustable resistance based on the excitation voltage *V*_{2d} between two terminals of the battery pack and the range voltage *V*_{(standard)} of the sampling unit.

13. The method according to claim 12, wherein keeping on adjusting the resistance value of the adjustable resistance based on the excitation voltage *V*_{2d} between two terminals of the battery pack and the range voltage *V*_{(standard)} of the sampling unit further comprises either one of:
i) if the excitation voltage *V*_{2d} between two terminals of the battery pack is equal to *V*_{(standard)},
adjusting the adjustable resistance to equate the resistance value *R* of the adjustable resistance with (*n*+1)*a*;
determining whether the excitation voltage *V*₂ₑ between two terminals of the battery pack is smaller than *V*_{(standard)} when the resistance value *R* of the adjustable resistance is equal to (*n*+1)*a*; and
if *V*₂ₑ<*V*_{(standard)}, taking the adjustable resistance as (*n*+1)*a*, and calculating the internal resistance of the battery pack based on the excitation voltage between two terminals of the battery pack, the excitation voltage between two terminals of the adjustable resistance and the resistance value of the adjustable resistance which are collected by the sampling unit at a time when *V*₂ₑ<*V*_{(standard)} and the resistance value *R* of the adjustable resistance is taken as (*n*+1)*a*;
or
ii) if the excitation voltage *V*_{2d} between two terminals of the battery pack collected by the sample unit is smaller than *V*_{(Standard)},
adjusting the adjustable resistance to equate the resistance value *R* of the adjustable resistance with (*n*-1)*a*;
determining whether the excitation voltage *V*_{2f} between two terminals of the battery pack is equal to *V*_{(standard)} when the resistance value *R* of the adjustable resistance to be equal to (*n*-1)*a*; and
if *V*_{2f}=*V*_{(standard)}, taking the resistance value *R* of the adjustable resistance as (*n*-1)*a*, and calculating the internal resistance of the battery pack based on the excitation voltage between two terminals of the battery pack, the excitation voltage between two terminals of the adjustable resistance and the resistance value of the adjustable resistance which are collected by the sampling unit at a time when *V*_{2f}=*V*_{(standard)} and the resistance value *R* of the adjustable resistance is taken as (*n*-1)*a*.

14. The method according to claim 13, further comprising either one of:
in case i):
if *V*₂ₑ=*V*_{(standard)}, keeping on adjusting the resistance value *R* of the adjustable resistance; and
when the resistance value *R* of the adjustable resistance satisfies that the excitation voltage between two terminals of the battery pack is equal to *V*_{(standard)} when *R*=(*n*+*w*-1)*a*, in which *w* is a number of times of fine adjustment, and the excitation voltage between two terminals of the battery pack is smaller than *V*_{(standard)} when *R*=(*n*+*w*)*a*, taking the resistance value of the adjustable resistance as (*n*+*w*)*a*, and calculating the internal resistance of the battery pack based on the excitation voltage between two terminals of the battery pack, the excitation voltage between two terminals of the adjustable resistance and the resistance value of the adjustable resistance which are collected by the sampling unit at a time when *V*₂ₑ=*V*_{(standard)} and the resistance value *R* of the adjustable resistance is taken as (*n*+*w*)*a*;
or
in case ii):
if *V*_{2f}<*V*_{(standard)}, keeping on adjusting the resistance value *R* of the adjustable resistance; and
when the resistance value *R* of the adjustable resistance satisfies that the excitation voltage between two terminals of the battery pack is equal to *V*_{(standard)} when *R*=(*n*-*y*-1)*a*, in which *y* is a number of times of fine adjustment, and the excitation voltage between two terminals of the battery pack is smaller than *V*_{(standard)} when *R*=(*n*-*y*)*a*, taking the resistance value of the adjustable resistance as (*n*-*y*-1)*a*, and calculating the internal resistance of the battery pack based on the excitation voltage between two terminals of the battery pack, the excitation voltage between two terminals of the adjustable resistance and the resistance value of the adjustable resistance which are collected by the sampling unit at a time when the resistance value *R* of the adjustable resistance is taken as (*n*-*y*-1)*a*.

15. The method according to claim 6, wherein the internal resistance of the battery pack is calculated by the control unit using a formula: *r*=PF×*V₂*/*I*, in which *I* is the excitation current in the loop circuit and is calculated by the excitation voltage between two terminals of the adjustable resistance and the resistance value of the adjustable resistance, and PF is a power coefficient of the loop circuit.

## Patentansprüche

1. Prüfvorrichtung für internen Widerstand, aufweisend:
ein Batteriepack (2);
einen Einstellwiderstand (3), verbunden mit dem Batteriepack (2) zur Bildung eines Regelkreises;
eine Erregerquelle (11), die an den Regelkreis gekoppelt ist, um den Regelkreis mit einer Erregung zu beaufschlagen, so dass ein Erregerstrom im Regelkreis erzeugt wird;
eine Abtasteinheit (4), die an den Regelkreis gekoppelt ist und für Erfassen einer Erregerspannung *V*₂ über zwei Klemmen des Batteriepacks (2), einer Erregerspannung *V*₁ über zwei Klemmen des Einstellwiderstands (3) und eines Widerstandswerts *R* des Einstellwiderstands (3) angewendet wird; und
eine Steuereinheit (5), die an die Abtasteinheit (4) gekoppelt ist und angewendet wird für Berechnen eines internen Widerstands des Batteriepacks (2) auf Basis der Erregerspannung *V*₂, der Erregerspannung *V*₁, und des Widerstandswerts *R*, die von der Abtasteinheit (4) zu einem Zeitpunkt erfasst werden, wenn die Erregerspannung *V*₂ im Wesentlichen gleich einer Bereichsspannung *V*_{(standard)} der Abtasteinheit (4) ist.

2. Vorrichtung nach Anspruch 1, wobei entweder
i) die Abtasteinheit ein CS5463 Abtastchip ist; oder
ii) die Erregerquelle eine Wechselstrom-Erregerquelle ist; oder
iii) die Vorrichtung ferner einen Transistor aufweist, der mit dem Regelkreis verbunden ist, wobei die Erregerquelle an ein Steuerende des Transistors gekoppelt ist, um die Erregung über den Transistor auf den Regelkreis anzuwenden.

3. Vorrichtung nach Anspruch 1, wobei die Steuereinheit den internen Widerstand des Batteriepacks mithilfe der Formel *r* = PF × *V*₂/*I* berechnet, darin bezeichnen *r* den internen Widerstand des Batteriepacks, *I* einen Erregerstrom im Regelkreis, berechnet durch Anwenden der Erregerspannung *V*₂ über zwei Klemmen des Einstellwiderstands, *R* den Widerstandswert des Einstellwiderstands und PF einen Leistungskoeffizient des Regelkreises.

4. Vorrichtung nach Anspruch 1, ferner aufweisend:
eine Widerstandswerteinstelleinheit, die an den Einstellwiderstand gekoppelt ist und für Grob- und Feineinstellen des Widerstandswerts *R* des Einstellwiderstands benutzt wird.

5. Vorrichtung nach Anspruch 4, wobei die Widerstandswerteinstelleinheit gesteuert wird für Einstellen des Widerstandswerts *R* des Einstellwiderstands durch die Steuereinheit auf Basis eines Verhältnisses zwischen der Erregerspannung *V*₂ über zwei Klemmen des Batteriepacks und der Bereichsspannung *V*_{(standard)} der Abtasteinheit.

6. Verfahren zum Überprüfen des internen Widerstands unter Anwenden der Prüfvorrichtung für internen Widerstand nach Anspruch 1, aufweisend die folgenden Schritte:
a) Anwenden einer Erregung auf den Regelkreis durch die Erregerquelle (1);
b) Erfassen einer Erregerspannung *V*₂ über die zwei Klemmen des Batteriepacks (2), einer Erregerspannung *V*₁ über die zwei Klemmen des Einstellwiderstands (3) und des Widerstandswerts *R* des Einstellwiderstands (3) durch die Abtasteinheit (4);
c) Einstellen des Widerstandswerts *R* des Einstellwiderstands (3), damit dieser gleich der Erregerspannung V₂ über die zwei Klemmen des Batteriepacks (2) mit der Bereichsspannung V_{(standard)} der Abtasteinheit (4) wird; und
d) Berechnen eines internen Widerstands *r* des Batteriepacks auf Basis der Erregerspannung *V*₁ und des Widerstandswerts *R*, die zu einem Zeitpunkt erfasst werden, wenn die Erregerspannung *V*₂ im Wesentlichen gleich einer Bereichsspannung *V*_{(standard)} der Abtasteinheit (4) ist.

7. Verfahren nach Anspruch 6, wobei Schritt c) Folgendes aufweist:
Grobeinstellen des Widerstandswerts *R* des Einstellwiderstands, bis die über die zwei Klemmen des Batteriepacks von der Abtasteinheit erfasste Erregungsspannung *V*₂ im Wesentlichen gleich der Bereichsspannung *V*_{(standard)} der Abtasteinheit ist;
Erhöhen des Widerstandswerts R des Einstellwiderstands, bis die von der Abtasteinheit über zwei Klemmen des Batteriepacks erfasste Erregerspannung *V*₂ kleiner ist als die Bereichsspannung *V*_{(standard)} der Abtasteinheit, und Aufzeichnen des Widerstandswerts des Einstellwiderstands zu diesem Zeitpunkt als *R*₂;
Aufzeichnen des Widerstandswerts des Einstellwiderstands, bei dem die Erregerspannung *V*₂ über die zwei Klemmen des Batteriepacks im Wesentlichen gleich der Bereichsspannung *V*_{(standard)} der Abtasteinheit während der letzten Zeit ist, als *R*₁;
Feineinstellen des Einstellwiderstands, damit die Erregerspannung *V*₂ über zwei Klemmen des Batteriepacks im Wesentlichen gleich der Bereichsspannung der Abtasteinheit ist; und
Berechnen des internen Widerstands des Batteriepacks auf Basis der Erregerspannung *V*₁ über zwei Klemmen des Einstellwiderstands, des Widerstandswerts *R* des Einstellwiderstands und der Erregerspannung *V*₂ über zwei Klemmen des Batteriepacks, die zu einem Zeitpunkt erfasst werden, wenn der Einstellwiderstand feineingestellt ist, so dass die Erregerspannung *V*₂ über zwei Klemmen des Batteriepacks im Wesentlichen gleich der Bereichsspannung *V*_{(standard)} der Abtasteinheit ist.

8. Verfahren nach Anspruch 7, wobei Feineinstellen des Einstellwiderstands Folgendes aufweist:
Einstellen des Einstellwiderstands, damit der Widerstandswert *R* des Einstellwiderstands gleich einem Durchschnitts-Widerstandswert *R*₃ von *R*₁ und *R*₂ ist;
Erfassen der Erregerspannung *V*₂ₐ über zwei Klemmen des Batteriepacks, wenn der Widerstandswert *R* des Einstellwiderstands gleich dem Durschnitts-Widerstandswert *R*₃ ist; und
Einstellen des Widerstandswerts *R* des Einstellwiderstands auf Basis der Erregerspannung *V*₂ₐ über zwei Klemmen des Batteriepacks und der Bereichsspannung *V*_{(standard)} der Abtasteinheit.

9. Verfahren nach Anspruch 8, wobei Einstellen des Widerstandswerts *R* des Einstellwiderstands auf Basis der Erregerspannung *V*₂ₐ über zwei Klemmen des Batteriepacks und der Bereichsspannung *V*_{(standard)} der Abtasteinheit Folgendes aufweist:
wenn die Erregerspannung *V*₂ₐ über zwei Klemmen des Batteriepacks gleich *V*_{(standard)} ist,
Einstellen des Einstellwiderstands, so dass der Widerstandswert *R* des Einstellwiderstands gleich einem Durchschnitts-Widerstandswert *R*₅ von *R*₂ und *R*₃ ist, wobei *R*₅ = *ma*, worin *m* eine in der Prüfvorrichtung eingestellte Ganzahlvariable und *a* eine Mindesteinheit für Feineinstellen des Einstellwiderstands sind;
Erfassen der Erregerspannung *V*_{2b} über zwei Klemmen des Batteriepacks, wenn der Widerstandswert *R* gleich dem Durchschnitts-Widerstandswert *R*₅ ist; und
Fortsetzen des Einstellens des Widerstandswerts *R* des Einstellwiderstands auf Basis der Erregerspannung *V*_{2b} über zwei Klemmen des Batteriepacks und der Bereichsspannung *V*_{(standard)} der Abtasteinheit.

10. Verfahren nach Anspruch 9, wobei Fortsetzen des Einstellens des Widerstandswerts *R* des Einstellwiderstands auf Basis der Erregerspannung *V*_{2b} über zwei Klemmen des Batteriepacks und der Bereichsspannung *V*_{(standard)} der Abtasteinheit ferner eines von Folgendem aufweist:
i) wenn die Erregerspannung *V*_{2b} über zwei Klemmen des Batteriepacks gleich *V*_{(standard)} ist,
Einstellen des Einstellwiderstands, so dass der Widerstandswert *R* des Einstellwiderstands gleich (*m*+1)*a* ist;
Bestimmen, ob die Erregerspannung *V*_{2c} über zwei Klemmen des Batteriepacks kleiner ist als *V*_{(standard),} wenn der Widerstandswert *R* des Einstellwiderstands gleich (*m*+1)*a* ist; und
wenn *V*_{2c}<*V*_{(standard)}, Ansetzen des Widerstandswerts *R* des Einstellwiderstands mit (*m*+1)*a* und Berechnen des internen Widerstands des Batteriepacks auf Basis der Erregerspannung über zwei Klemmen des Batteriepacks, der Erregerspannung über zwei Klemmen des Einstellwiderstands und des Widerstandswerts des Einstellwiderstands, die von der Abtasteinheit zu einem Zeitpunkt erfasst werden, wenn *V*_{2c}<*V*_{(standard)} und der Widerstandswert des Einstellwiderstands mit (*m*+1)a angesetzt werden;
oder
ii) wenn die Erregerspannung *V*_{2b} über zwei Klemmen des Batteriepacks kleiner ist als *V*_{(standard)} der Abtasteinheit,
Fortsetzen des Einstellens des Einstellwiderstands, bis der Widerstandswert *R* des Einstellwiderstands gleich (*m*-1)*a* ist;
Bestimmen, ob die Erregerspannung *V*_{2g} über zwei Klemmen des Batteriepacks gleich *V*_{(standard)} ist, wenn der Widerstandswert *R* des Einstellwiderstands gleich (*m*-1)*a* ist; und
wenn *V*_{2g}=*V*_{(standard)}, Ansetzen des Einstellwiderstands mit (*m*-1)*a* und Berechnen des internen Widerstands des Batteriepacks auf Basis der Erregerspannung über zwei Klemmen des Batteriepacks, der Erregerspannung über zwei Klemmen des Einstellwiderstands und des Widerstandswerts des Einstellwiderstands, die von der Abtasteinheit zu einem Zeitpunkt erfasst werden, wenn *V*_{2g}=*V*_{(standard)} und der Widerstandswert *R* mit (*m*-1) *a* angesetzt werden.

11. Verfahren nach Anspruch 10, ferner aufweisend eines von Folgendem:
im Fall i):
wenn *V*_{2c}=*V*_{(standard)}, Fortsetzen des Einstellens des Widerstandswerts *R* des Einstellwiderstands; und
wenn der Widerstandswert *R* des Einstellwiderstands der Forderung Rechnung trägt, dass die Erregerspannung über zwei Klemmen des Batteriepacks gleich *V*_{(standard)}, wenn *R* = (*m*+x-1)*a*, wobei *x* eine Anzahl von Feineinstellvorgängen bezeichnet, und die Erregerspannung über zwei Klemmen des Batteriepacks kleiner ist als *V*_{(standard)}, wenn *R* = (*m*+*x*)*a*, Ansetzen des Widerstandswerts *R* des Einstellwiderstands mit (*m*+*x*)*a*, und Berechnen des internen Widerstands des Batteriepacks auf Basis der Erregerspannung über zwei Klemmen des Batteriepacks, der Erregerspannung über zwei Klemmen des Einstellwiderstands und des Widerstandswerts des Einstellwiderstands, die von der Abtasteinheit zu einem Zeitpunkt, wenn *V*_{2c}=*V*_{(standard)} und der Widerstandswert *R* mit (*m*+*x*)*a* angesetzt wird, erfasst werden,
oder
im Fall ii):
wenn *V*_{2g}=*V*_{(standard)}, Fortsetzen des Einstellens des Widerstandswerts *R* des Einstellwiderstands; und
wenn der Widerstandswert *R* des Einstellwiderstands der Forderung Rechnung trägt, dass die Erregerspannung über zwei Klemmen des Batteriepacks gleich *V*_{(standard)}, wenn *R* = (*m*-*z*-1)*a*, wobei *z* eine Anzahl von Feineinstellvorgängen bezeichnet, und die Erregerspannung über zwei Klemmen des Batteriepacks kleiner ist als *V*_{(standard)}, wenn *R* = (*m*-*z*)*a*, Ansetzen des Widerstandswerts *R* des Einstellwiderstands mit (*m-z*-1)*a*, und Berechnen des internen Widerstands des Batteriepacks auf Basis der Erregerspannung über zwei Klemmen des Batteriepacks, der Erregerspannung über zwei Klemmen des Einstellwiderstands und des Widerstandswerts des Einstellwiderstands, die von der Abtasteinheit zu einem Zeitpunkt, wenn *V*_{2g}<*V*_{(standard)} und der Widerstandswert *R* mit (*m*-*z*-1)*a* angesetzt wird, erfasst werden.

12. Verfahren nach Anspruch 8, wobei Einstellen des Widerstandswerts des Einstellwiderstands auf Basis der Erregerspannung *V*₂ₐ über zwei Klemmen des Batteriepacks und der Bereichsspannung *V*_{(standard)} der Abtasteinheit Folgendes aufweist:
wenn die Erregerspannung *V*₂ₐ über zwei Klemmen des Batteriepacks kleiner ist als *V*_{(standard)}, Einstellen des Einstellwiderstands, so dass der Widerstandswert *R* des Einstellwiderstands gleich einem Durchschnitts-Widerstandswert *R*₄ von *R*1 und *R*₃ ist, wobei *R*₄ = *na*, worin *n* eine in der Prüfvorrichtung eingestellte Ganzahlvariable und *a* eine Mindesteinheit für Feineinstellen des Einstellwiderstands sind;
Erfassen der Erregerspannung *V*_{2d} über zwei Klemmen des Batteriepacks; und
Fortsetzen des Einstellens des Widerstandswerts *R* des Einstellwiderstands auf Basis der Erregerspannung *V*_{2d} über zwei Klemmen des Batteriepacks und der Bereichsspannung *V*_{(standard)} der Abtasteinheit.

13. Verfahren nach Anspruch 12, wobei Fortsetzen des Einstellens des Widerstandswerts des Einstellwiderstands auf Basis der Erregerspannung *V*_{2d} über zwei Klemmen des Batteriepacks und der Bereichsspannung *V*_{(standard)} der Abtasteinheit ferner eines von Folgendem aufweist:
i) wenn die Erregerspannung *V*_{2d} über zwei Klemmen des Batteriepacks gleich *V*_{(standard)} ist,
Einstellen des Einstellwiderstands des Einstellwiderstands, bis der Widerstandswert *R* des Einstellwiderstands gleich (*n*+1)*a* ist;
Bestimmen, ob die Erregerspannung *V*₂ₑ über zwei Klemmen des Batteriepacks kleiner ist als *V*_{(standard)}. wenn der Widerstandswert *R* des Einstellwiderstands gleich (*n*+1)*a* ist; und
wenn *V*₂ₑ<*V*_{(standard)}, Ansetzen des Einstellwiderstands mit (*n*+1)*a* und Berechnen des internen Widerstands des Batteriepacks auf Basis der Erregerspannung über zwei Klemmen des Batteriepacks, der Erregerspannung über zwei Klemmen des Einstellwiderstands und des Widerstandswerts des Einstellwiderstands, die von der Abtasteinheit zu einem Zeitpunkt erfasst werden, wenn *V*₂ₑ<*V*_{(standard)} und der Widerstandswert *R* mit (*n*+1)*a* angesetzt werden;
oder
ii) wenn die von der Abtasteinheit erfasste Erregerspannung *V*_{2d} über zwei Klemmen des Batteriepacks kleiner ist als *V*_{(standard),}
Einstellen des Einstellwiderstands des Einstellwiderstands, bis der Widerstandswert *R* des Einstellwiderstands gleich (*n*-1)*a* ist;
Bestimmen, ob die Erregerspannung *V*_{2f} über zwei Klemmen des Batteriepacks gleich *V*_{(standard)} ist, wenn der Widerstandswert *R* des Einstellwiderstands gleich (*n*-1)*a* ist; und
wenn *V*_{2f}=*V*_{(standard)}, Ansetzen des Widerstandswerts *R* des Einstellwiderstands mit (*n*-1)*a* und Berechnen des internen Widerstands des Batteriepacks auf Basis der Erregerspannung über zwei Klemmen des Batteriepacks, der Erregerspannung über zwei Klemmen des Einstellwiderstands und des Widerstandswerts des Einstellwiderstands, die von der Abtasteinheit zu einem Zeitpunkt erfasst werden, wenn *V*_{2f}=*V*_{(standard)} und der Widerstandswert *R* mit (*n*-1)*a* angesetzt werden.

14. Verfahren nach Anspruch 13, ferner aufweisend eines von Folgendem:
im Fall i):
wenn *V*₂ₑ=*V*_{(standard)}, Fortsetzen des Einstellens des Widerstandswerts *R* des Einstellwiderstands; und
wenn der Widerstandswert *R* des Einstellwiderstands der Forderung Rechnung trägt, dass die Erregerspannung über zwei Klemmen des Batteriepacks gleich *V*_{(standard)}, wenn *R* = (*n*+*w*-1)*a*, wobei *w* eine Anzahl von Feineinstellvorgängen bezeichnet, und die Erregerspannung über zwei Klemmen des Batteriepacks kleiner ist als *V*_{(standard)}, wenn *R* = (*n*+*w*)*a*, Ansetzen des Widerstandswerts des Einstellwiderstands mit (*n*+*w*)*a*, und Berechnen des internen Widerstands des Batteriepacks auf Basis der Erregerspannung über zwei Klemmen des Batteriepacks, der Erregerspannung über zwei Klemmen des Einstellwiderstands und des Widerstandswerts des Einstellwiderstands, die von der Abtasteinheit zu einem Zeitpunkt, wenn *V*₂ₑ=*V*_{(standard)} und der Widerstandswert *R* mit (*n*+*w*)*a* angesetzt wird, erfasst werden;
oder
im Fall ii):
wenn *V*₂ₜ<*V*_{(standard)}, Fortsetzen des Einstellens des Widerstandswerts *R* des Einstellwiderstands; und
wenn der Widerstandswert *R* des Einstellwiderstands der Forderung Rechnung trägt, dass die Erregerspannung über zwei Klemmen des Batteriepacks gleich *V*_{(standard)}, wenn *R* = (*n*-*y*-1)*a*, wobei *y* eine Anzahl von Feineinstellvorgängen bezeichnet, und die Erregerspannung über zwei Klemmen des Batteriepacks kleiner ist als *V*_{(standard)}, wenn *R* = (*n*-*y*)*a*, Ansetzen des Widerstandswerts *R* des Einstellwiderstands mit (*n-y*)*a*, und Berechnen des internen Widerstands des Batteriepacks auf Basis der Erregerspannung über zwei Klemmen des Batteriepacks, der Erregerspannung über zwei Klemmen des Einstellwiderstands und des Widerstandswerts des Einstellwiderstands, die von der Abtasteinheit zu einem Zeitpunkt, wenn der Widerstandswert *R* mit (*n*-*y*-1)*a* angesetzt wird, erfasst werden.

15. Verfahren nach Anspruch 6, wobei der interne Widerstand des Batteriepacks von einer Steuereinheit unter Anwenden einer Formel: *r* = PF × *V*₂/*I* berechnet wird, worin den *I* den Erregerstrom im Regelkreis bezeichnet, und die Berechnung durch die Erregerspannung über zwei Klemmen des Einstellwiderstands und den Widerstandswert des Einstellwiderstands erfolgt, und PF ein Leistungskoeffizient des Regelkreises ist.

## Revendications

1. Dispositif de test de résistance interne, comprenant :
un bloc-batterie (2) ;
une résistance ajustable (3) connectée avec le bloc-batterie (2) pour former un circuit en boucle ;
une source d'excitation (11) couplée au circuit en boucle pour appliquer une excitation au circuit en boucle de façon à générer un courant d'excitation dans le circuit en boucle ;
une unité d'échantillonnage (4) couplée au circuit en boucle et utilisée pour collecter une tension d'excitation *V*₂ entre deux bornes du bloc-batterie (2), une tension d'excitation *V*₁ entre deux bornes de la résistance ajustable (3) et une valeur de résistance *R* de la résistance ajustable (3) ; et
une unité de contrôle (5) couplée à l'unité d'échantillonnage (4) et utilisée pour calculer une résistance interne du bloc-batterie (2) sur la base de la tension d'excitation *V*₂, de la tension d'excitation *V*₁ et de la valeur de résistance *R* qui sont collectées par l'unité d'échantillonnage (4) à un moment où la tension d'excitation *V*₂ est sensiblement égale à une plage de tension *V*_{(standard)} de l'unité d'échantillonnage (4).

2. Dispositif selon la revendication 1, dans lequel soit
i) l'unité d'échantillonnage est une puce d'échantillonnage CS5463 ; soit
ii) la source d'excitation est une source d'excitation en courant alternatif ; soit
iii) le dispositif comprend en outre un transistor connecté dans le circuit en boucle, dans lequel la source d'excitation est couplée à une extrémité de contrôle du transistor pour appliquer l'excitation au circuit en boucle par l'intermédiaire du transistor.

3. Dispositif selon la revendication 1, dans lequel l'unité de contrôle calcule la résistance interne du bloc-batterie en utilisant une formule : *r* = PFx*V*₂/*I*, dans laquelle *r* est la résistance interne du bloc-batterie, *I* est un courant d'excitation dans le circuit en boucle et calculé en utilisant la tension d'excitation *V*₂ entre deux bornes de la résistance ajustable et la valeur de résistance *R* de la résistance ajustable, et PF est un coefficient de puissance du circuit en boucle.

4. Dispositif selon la revendication 1, comprenant en outre :
une unité d'ajustement de valeur de résistance couplée à la résistance ajustable et utilisée pour ajuster grossièrement et finement la valeur de résistance *R* de la résistance ajustable.

5. Dispositif selon la revendication 4, dans lequel l'unité d'ajustement de valeur de résistance est contrôlée de façon à ajuster la valeur de résistance *R* de la résistance ajustable par l'unité de contrôle sur la base d'une relation de la tension d'excitation *V*₂ entre deux bornes du bloc-batterie avec la plage de tension *V*_{(standard)} de l'unité d'échantillonnage.

6. Procédé de test de résistance interne utilisant le dispositif de test de résistance interne selon la revendication 1, comprenant des étapes de :
a) application d'une excitation au circuit en boucle par la source d'excitation (1) ;
b) collecte d'une tension d'excitation *V*₂ entre les deux bornes du bloc-batterie (2), d'une tension d'excitation *V*₁ entre les deux bornes de la résistance ajustable (3) et de la valeur de résistance *R* de la résistance ajustable (3) par l'unité d'échantillonnage (4) ;
c) ajustement de la valeur de résistance *R* de la résistance ajustable (3) pour que la tension d'excitation *V*₂ entre les deux bornes du bloc-batterie (2) soit égale à la plage de tension *V*_{(standard)} de l'unité d'échantillonnage (4) ; et
d) calcul d'une résistance interne *r* du bloc-batterie sur la base de la tension d'excitation *V*₂, de la tension d'excitation *V*₁ et de la valeur de résistance *R* qui sont collectées à un moment où la tension d'excitation *V*₂ est sensiblement égale à une plage de tension *V*_{(standard)} de l'unité d'échantillonnage (4).

7. Procédé selon la revendication 6, dans lequel l'étape c) comprend :
l'ajustement grossier de la valeur de résistance *R* de la résistance ajustable jusqu'à ce que la tension d'excitation *V*₂ entre deux bornes du bloc-batterie collectée par l'unité d'échantillonnage soit sensiblement égale à la plage de tension *V*_{(standard)} de l'unité d'échantillonnage ;
l'augmentation de la valeur de résistance *R* de la résistance ajustable jusqu'à ce que la tension d'excitation *V*₂ entre deux bornes du bloc-batterie collectée par l'unité d'échantillonnage soit plus petite que la plage de tension *V*_{(standard)} de l'unité d'échantillonnage, et l'enregistrement de la valeur de résistance de la résistance ajustable à ce moment comme *R*₂ ;
l'enregistrement de la valeur de résistance de la résistance ajustable, par laquelle la tension d'excitation *V*₂ entre deux bornes du bloc-batterie est sensiblement égale à la plage de tension *V*_{(standard)} de l'unité d'échantillonnage pour la dernière fois, comme *R*₁ ;
l'ajustement fin de la résistance ajustable pour que la tension d'excitation *V*₂ entre deux bornes du bloc-batterie soit sensiblement égale à la plage de tension de l'unité d'échantillonnage ; et
le calcul de la résistance interne du bloc-batterie sur la base de la tension d'excitation *V*₁ entre deux bornes de la résistance ajustable, de la valeur de résistance *R* de la résistance ajustable et de la tension d'excitation *V*₂ entre deux bornes du bloc-batterie qui sont collectées à un moment où la résistance ajustable est finement ajustée pour que la tension d'excitation *V*₂ entre deux bornes du bloc-batterie soit sensiblement égale à la plage de tension *V*_{(standard)} de l'unité d'échantillonnage.

8. Procédé selon la revendication 7, dans lequel l'ajustement fin de la résistance ajustable comprend :
l'ajustement de la résistance ajustable pour que la valeur de résistance *R* de la résistance ajustable soit égale à une valeur de résistance moyenne *R*₃ de *R*₁ et *R*₂ ;
la collecte de la tension d'excitation *V*₂ₐ entre deux bornes du bloc-batterie lorsque la valeur de résistance *R* de la résistance ajustable est égale à la valeur de résistance moyenne *R*₃ ; et
l'ajustement de la valeur de résistance *R* de la résistance ajustable sur la base de la tension d'excitation *V*₂ₐ entre deux bornes du bloc-batterie et de la plage de tension *V*_{(standard)} de l'unité d'échantillonnage.

9. Procédé selon la revendication 8, dans lequel l'ajustement de la valeur de résistance *R* de la résistance ajustable sur la base de la tension d'excitation *V*₂ₐ entre deux bornes du bloc-batterie et de la plage de tension *V*_{(standard)} de l'unité d'échantillonnage comprend :
si la tension d'excitation *V*₂ₐ entre deux bornes du bloc-batterie est égale à *V*_{(standard)},
l'ajustement de la résistance ajustable pour que la valeur de résistance *R* de la résistance ajustable soit égale à une valeur de résistance moyenne *R*₅ de *R*₂ et *R*₃, dans laquelle *R*₅ = *ma*, où *m* est une variable entière fixée dans le dispositif de test, et a est une unité minimum pour ajuster finement la résistance ajustable ;
la collecte de la tension d'excitation *V*_{2b} entre deux bornes du bloc-batterie lorsque la valeur de résistance *R* est égale à la valeur de résistance moyenne *R*₅ ; et
la prolongation de l'ajustement de la valeur de résistance *R* de la résistance ajustable sur la base de la tension d'excitation *V*_{2b} entre deux bornes du bloc-batterie et de la plage de tension *V*_{(standard)} de l'unité d'échantillonnage.

10. Procédé selon la revendication 9, dans lequel la prolongation de l'ajustement de la valeur de résistance *R* de la résistance ajustable sur la base de la tension d'excitation *V*_{2b} entre deux bornes du bloc-batterie et de la plage de tension *V*_{(standard)} de l'unité d'échantillonnage comprend en outre l'un ou l'autre parmi :
i) si la tension d'excitation *V*_{2b} entre deux bornes du bloc-batterie est égale à *V*_{(standard)},
l'ajustement de la résistance ajustable pour que la valeur de résistance *R* de la résistance ajustable soit égale à (*m*+1)*a* ;
la détermination si la tension d'excitation *V*_{2c} entre deux bornes du bloc-batterie est plus petite que *V*_{(standard)} lorsque la valeur de résistance *R* de la résistance ajustable est égale à (*m*+1)*a* ; et
si *V*_{2c} < *V*_{(standard)}, la considération de la valeur de résistance *R* de la résistance ajustable comme (*m*+1)*a*, et le calcul de la résistance interne du bloc-batterie sur la base de la tension d'excitation entre deux bornes du bloc-batterie, de la tension d'excitation entre deux bornes de la résistance ajustable et de la valeur de résistance de la résistance ajustable qui sont collectées par l'unité d'échantillonnage à un moment où *V*_{2c} < *V*_{(standard)} et la valeur de résistance *R* de la résistance ajustable est considérée comme (*m*+1)*a* ;
ou
ii) si la tension d'excitation *V*_{2b} entre deux bornes du bloc-batterie est plus petite que *V*_{(standard)} de l'unité d'échantillonnage,
la prolongation de l'ajustement de la résistance ajustable pour que la valeur de résistance *R* de la résistance ajustable soit égale à (*m*-1)*a* ;
la détermination si la tension d'excitation *V*_{2g} entre deux bornes du bloc-batterie est égale à *V*_{(standard)} lorsque la valeur de résistance *R* de la résistance ajustable est égale à (*m*-1)*a* ; et
si *V*_{2g} = *V*_{(standard)}, la considération de la résistance ajustable comme (*m*-1)*a*, et le calcul de la résistance interne du bloc-batterie sur la base de la tension d'excitation entre deux bornes du bloc-batterie, de la tension d'excitation entre deux bornes de la résistance ajustable et de la valeur de résistance de la résistance ajustable qui sont collectées par l'unité d'échantillonnage à un moment où *V*_{2g} = *V*_{(standard)} et la valeur de résistance *R* est considérée comme (*m*-1)*a*.

11. Procédé selon la revendication 10, comprenant en outre l'un ou l'autre parmi :
dans le cas i) :
si *V*_{2c} = *V*_{(standard)}, la prolongation de l'ajustement de la valeur de résistance *R* de la résistance ajustable ; et
lorsque la valeur de résistance *R* de la résistance ajustable satisfait à ce que la tension d'excitation entre deux bornes du bloc-batterie soit égale à *V*_{(standard)} lorsque *R* = (*m*+*x*-1)*a*, dans laquelle *x* est un nombre de fois d'ajustement fin, et que la tension d'excitation entre deux bornes du bloc-batterie est plus petite que *V*_{(standard)} lorsque *R* = (*m*+*x*) *a*, la considération de la valeur de résistance *R* de la résistance ajustable comme (*m*+*x*)*a*, et le calcul de la résistance interne du bloc-batterie sur la base de la tension d'excitation entre deux bornes du bloc-batterie, de la tension d'excitation entre deux bornes de la résistance ajustable et de la valeur de résistance de la résistance ajustable qui sont collectées par l'unité d'échantillonnage à un moment où *V*_{2c} = *V*_{(standard)} et la valeur de résistance *R* de la résistance ajustable est considérée comme (*m*+*x*)*a*,
ou
dans le cas ii) :
si *V*_{2g} < *V*_{(standard)}, la prolongation de l'ajustement de la valeur de résistance *R* de la résistance ajustable ; et
lorsque la valeur de résistance *R* de la résistance ajustable satisfait à ce que la tension d'excitation entre deux bornes du bloc-batterie soit égale à *V*_{(standard)} lorsque *R* = (*m*-*z*-1)*a*, dans laquelle *z* est un nombre de fois d'ajustement fin, et que la tension d'excitation entre deux bornes du bloc-batterie est plus petite que *V*_{(standard)} lorsque *R* = (*m*-*z*)*a*, la considération de la valeur de résistance *R* de la résistance ajustable comme (*m-z*-1)*a*, et le calcul de la résistance interne du bloc-batterie sur la base de la tension d'excitation entre deux bornes du bloc-batterie, de la tension d'excitation entre deux bornes de la résistance ajustable et de la valeur de résistance de la résistance ajustable qui sont collectées par l'unité d'échantillonnage à un moment où *V*_{2g} < *V*_{(standard)} et la valeur de résistance *R* de la résistance ajustable est considérée comme (*m*-*z*-1)*a*.

12. Procédé selon la revendication 8, dans lequel l'ajustement de la valeur de résistance de la résistance ajustable sur la base de la tension d'excitation *V*₂ₐ entre deux bornes du bloc-batterie et de la plage de tension *V*_{(standard)} de l'unité d'échantillonnage comprend :
si la tension d'excitation *V*₂ₐ entre deux bornes du bloc-batterie est plus petite que *V*_{(standard)},
l'ajustement de la résistance ajustable pour que la valeur de résistance *R* de la résistance ajustable soit égale à une valeur de résistance moyenne *R*₄ de *R*₁ et *R*₃, dans laquelle *R*₄ = *na*, où *n* est une variable entière fixée dans le dispositif de test, et *a* est une unité minimum pour ajuster finement la résistance ajustable ;
la collecte de la tension d'excitation *V*_{2d} entre deux bornes du bloc-batterie ; et
la prolongation de l'ajustement de la valeur de résistance *R* de la résistance ajustable sur la base de la tension d'excitation *V*_{2d} entre deux bornes du bloc-batterie et de la plage de tension *V*_{(standard)} de l'unité d'échantillonnage.

13. Procédé selon la revendication 12, dans lequel la prolongation de l'ajustement de la valeur de résistance de la résistance ajustable sur la base de la tension d'excitation *V*_{2d} entre deux bornes du bloc-batterie et de la plage de tension *V*_{(standard)} de l'unité d'échantillonnage comprend en outre l'un ou l'autre parmi :
i) si la tension d'excitation *V*_{2d} entre deux bornes du bloc-batterie est égale à *V*_{(standard)},
l'ajustement de la résistance ajustable pour que la valeur de résistance *R* de la résistance ajustable soit égale à (*n*+1)*a* ;
la détermination si la tension d'excitation *V*_{2c} entre deux bornes du bloc-batterie est plus petite que *V*_{(standard)} lorsque la valeur de résistance *R* de la résistance ajustable est égale à (*n*+1)*a* ; et
si *V*_{2c} < *V*_{(standard)}, la considération de la résistance ajustable comme (*n*+1)*a*, et le calcul de la résistance interne du bloc-batterie sur la base de la tension d'excitation entre deux bornes du bloc-batterie, de la tension d'excitation entre deux bornes de la résistance ajustable et de la valeur de résistance de la résistance ajustable qui sont collectées par l'unité d'échantillonnage à un moment où *V*_{2c} < *V*_{(standard)} et la valeur de résistance *R* de la résistance ajustable est considérée comme (*n*+1)*a* ;
ou
ii) si la tension d'excitation *V*_{2d} entre deux bornes du bloc-batterie collectée par l'unité d'échantillonnage est plus petite que *V*_{(standard)},
l'ajustement de la résistance ajustable pour que la valeur de résistance *R* de la résistance ajustable soit égale à (*n*-1)*a* ;
la détermination si la tension d'excitation *V*_{2f} entre deux bornes du bloc-batterie est égale à *V*_{(standard)} lorsque la valeur de résistance *R* de la résistance ajustable est égale à (*n*-1)*a* ; et
si *V*_{2f} = *V*_{(standard)}, la considération de la valeur de résistance *R* de la résistance ajustable comme (*n*-1)*a*, et le calcul de la résistance interne du bloc-batterie sur la base de la tension d'excitation entre deux bornes du bloc-batterie, de la tension d'excitation entre deux bornes de la résistance ajustable et de la valeur de résistance de la résistance ajustable qui sont collectées par l'unité d'échantillonnage à un moment où *V*_{2f} = *V*_{(standard)} et la valeur de résistance *R* de la résistance ajustable est considérée comme (*n*-1)*a*.

14. Procédé selon la revendication 13, comprenant en outre l'un ou l'autre parmi :
dans le cas i) :
si *V*_{2c} = *V*_{(standard)}, la prolongation de l'ajustement de la valeur de résistance *R* de la résistance ajustable ; et
lorsque la valeur de résistance *R* de la résistance ajustable satisfait à ce que la tension d'excitation entre deux bornes du bloc-batterie soit égale à *V*_{(standard)} lorsque *R* = (*n*+*w*-1)*a*, dans laquelle *w* est un nombre de fois d'ajustement fin, et que la tension d'excitation entre deux bornes du bloc-batterie est plus petite que *V*_{(standard)} lorsque *R* = (*n*+*w*) *a*, la considération de la valeur de résistance de la résistance ajustable comme (*n*+*w*)*a*, et le calcul de la résistance interne du bloc-batterie sur la base de la tension d'excitation entre deux bornes du bloc-batterie, de la tension d'excitation entre deux bornes de la résistance ajustable et de la valeur de résistance de la résistance ajustable qui sont collectées par l'unité d'échantillonnage à un moment où *V*_{2c} = *V*_{(standard)} et la valeur de résistance *R* de la résistance ajustable est considérée comme (*n*+*w*)*a* ;
ou
dans le cas ii) :
si *V*_{2f} < *V*_{(standard)}, la prolongation de l'ajustement de la valeur de résistance *R* de la résistance ajustable ; et
lorsque la valeur de résistance *R* de la résistance ajustable satisfait à ce que la tension d'excitation entre deux bornes du bloc-batterie soit égale à *V*_{(standard)} lorsque *R* = (*n*-*y*-1)*a*, dans laquelle *y* est un nombre de fois d'ajustement fin, et que la tension d'excitation entre deux bornes du bloc-batterie est plus petite que *V*_{(standard)} lorsque *R* = (*n-y*) *a*, la considération de la valeur de résistance de la résistance ajustable comme (*n*-*y*-1)*a*, et le calcul de la résistance interne du bloc-batterie sur la base de la tension d'excitation entre deux bornes du bloc-batterie, de la tension d'excitation entre deux bornes de la résistance ajustable et de la valeur de résistance de la résistance ajustable qui sont collectées par l'unité d'échantillonnage à un moment où la valeur de résistance *R* de la résistance ajustable est considérée comme (*n*-*y*-1)*a*.

15. Procédé selon la revendication 6, dans lequel la résistance interne du bloc-batterie est calculée par l'unité de contrôle en utilisant une formule : *r* = PFx*V*₂/*I*, dans laquelle *I* est le courant d'excitation dans le circuit en boucle et est calculé par la tension d'excitation entre deux bornes de la résistance ajustable et la valeur de résistance de la résistance ajustable, et PF est un coefficient de puissance du circuit en boucle.
